# EUROPEAN PATENT APPLICATION

(11) **EP 4 742 879 A1**
(43) Date of publication of application: **13.05.2026**
(21) Application number: 24948936.0
(22) Date of filing: 12.08.2024
(51) Int. Cl.: H10P 72/00, F16L 55/02, B01D 47/02, B01D 47/06, B01D 53/78

(54) **GAS CONTROL SYSTEM FOR SEMICONDUCTOR EQUIPMENT**

(30) Priority: 02.08.2024 KR 20240103078
(71) Applicant: Oh, Seung Hwan, Seongbuk-gu Seoul 02822 (KR)
(72) Inventor: SHIN, Gunho, Seoul 05045 (KR); OH, Seung Hwan, Seoul 02822 (KR)
(74) Representative: Kim Kang, Jae Hee
(86) International application number: PCT/KR2024/011943
(87) International publication number: WO 2026/029243

(57) **Abstract**

The gas control system for semiconductor equipment of present invention comprises a first process chamber, a first exhaust pipe, a first inlet pipe, an energy dissipating device for dissipating energy of the gas, a sub-pipe, a main pipe, a first energy controller for controlling a first energy of the gas passing through the first inlet pipe, and a second energy controller for controlling a second energy of the gas passing through the sub-pipe, wherein the gas is supplied to the energy dissipating device through the first exhaust pipe and the first inlet pipe, thereafter the gas is discharged to the outside through the sub-pipe and the main pipe, the first energy of the gas in the first inlet pipe is controlled to a constant value by the first energy controller, and the second energy of the gas in the sub-pipe is controlled to a constant value by the second energy controller.

## Description

### TECHNICAL FIELD

The present invention relates to a gas control system for semiconductor equipment. Specifically, the present invention relates to the gas control system for semiconductor equipment that improves the stability of a semiconductor process chamber and the spatial efficiency of a semiconductor production line by controlling the pressure of gas discharged after a semiconductor process is performed.

### BACKGROUND ART

Conventionally, a semiconductor manufacturing plant (semiconductor production line) may include manufacturing equipment and utilities necessary for operating the equipment. The utilities may include various pipes, conduits, wiring, facilities, and ducts for supplying electricity, gas, water, chemicals, and the like. The pipes, conduits, wiring, and other components may be densely installed within a limited space.

When a large number of pipes are connected to a utility main pipe, an overload may be applied to the utility main pipe, whereas when only a small number of pipes are connected to the utility main pipe, the spatial efficiency of the semiconductor manufacturing plant may be reduced.

Accordingly, in recent years, research has been continuously conducted to improve the plant efficiency of semiconductor manufacturing plants by increasing the number of pipes connected to the utility main pipe, or the number of semiconductor process chambers connected to the utility main pipe, while reducing the load applied to the utility main pipe.

### DESCRIPTION OF EMBODIMENTS

### TECHNICAL PROBLEM

The technical problem to be solved by the present invention is to provide a gas control system for semiconductor equipment that controls the energy of gas passing through a sub-pipe connected to a main pipe.

By using the gas control system for semiconductor equipment according to the present invention, a semiconductor production line with improved spatial efficiency may be provided by increasing the number of semiconductor process chambers relative to the number of main pipes.

The problems that the present invention is trying to solve are not limited to the problems mentioned above, and other problems that are not mentioned can be clearly understood by those skilled in the art from the description below.

### SOLUTION TO PROBLEM

A gas control system for semiconductor equipment according to some embodiments of the present invention for achieving the above technical problem comprises a first process chamber in which a first semiconductor process is performed, a first exhaust pipe connected to the first process chamber and through which gas used in the first semiconductor process is discharged, a first inlet pipe connected to the first exhaust pipe, an energy dissipating device connected to the first inlet pipe to dissipate energy of the gas supplied through the first inlet pipe, a sub-pipe through which the gas having passed through the energy dissipating device is discharged, a main pipe connected to the sub-pipe, a first energy controller disposed in the first inlet pipe to control a first energy of the gas passing through the first inlet pipe, and a second energy controller disposed in the sub-pipe to control a second energy of the gas passing through the sub-pipe, wherein the gas is supplied to the energy dissipating device through the first exhaust pipe and the first inlet pipe, wherein thereafter the gas is discharged to the outside through the sub-pipe and the main pipe, wherein the first energy of the gas in the first inlet pipe is controlled to a constant value by the first energy controller, and wherein the second energy of the gas in the sub-pipe is controlled to a constant value by the second energy controller.

The gas control system for semiconductor equipment with improved stability may be provided because the energy of the gas inside the pipe is constantly controlled.

In some embodiments, wherein the first energy comprises a first pressure energy and a first kinetic energy, and wherein the first energy controller controls the first pressure energy of the gas to a constant value.

In some embodiments, wherein the second energy comprises a second pressure energy and a second kinetic energy, and wherein the first kinetic energy of the gas in the first inlet pipe is less than the second kinetic energy of the gas in the sub-pipe.

In some embodiments, wherein a width of the first inlet pipe is greater than a width of the sub-pipe.

In some embodiments, wherein the sub-pipe includes a section whose width gradually decreases from the energy dissipating device toward the main pipe.

In some embodiments, wherein the energy dissipating device comprises a scrubber, the scrubber comprising a scrubbing chamber defining a scrubbing space for scrubbing impurities contained in the gas, a scrubbing plate disposed in the scrubbing chamber and a plurality of scrubbing holes penetrating the scrubbing plate, wherein the gas loses energy while passing through the plurality of scrubbing holes.

In some embodiments, the gas control system further comprises a solution supply nozzle supplying a scrubbing solution onto an upper surface of the scrubbing plate, and wherein at least a portion of the impurities contained in the gas dissolves into the scrubbing solution on the upper surface of the scrubbing plate after the gas ascends through the plurality of scrubbing holes.

The gas control system for semiconductor equipment according to some embodiments further comprises a second process chamber different from the first process chamber, in which a second semiconductor process is performed, a second exhaust pipe connected to the second process chamber and through which gas used in the second semiconductor process is discharged, a second inlet pipe having one end connected to the second exhaust pipe and the other end connected to the energy dissipating device and a third energy controller disposed in the second inlet pipe to control a third energy of the gas passing through the second inlet pipe, wherein the first energy includes a first pressure energy and a first kinetic energy, wherein the third energy includes a third pressure energy and a third kinetic energy, and wherein the first pressure energy and the third pressure energy are equal.

In some embodiments, wherein the second energy includes a second pressure energy and a second kinetic energy, and wherein the third kinetic energy of the gas in the second inlet pipe is less than the second kinetic energy of the gas in the sub-pipe.

The gas control system for semiconductor equipment according to some embodiments further comprises a second process chamber different from the first process chamber, in which a second semiconductor process is performed and a second exhaust pipe having one end connected to the second process chamber and the other end connected to the first inlet pipe, the second exhaust pipe discharging gas used in the second semiconductor process.

The gas control system for semiconductor equipment according to some embodiments further comprises a first pressure sensor measuring a first pressure of the gas passing through the first inlet pipe, wherein the first energy controller includes a first rotation module capable of rotating, wherein when an absolute value of the first pressure measured by the first pressure sensor is greater than a first pressure set value, a rotation speed of the first rotation module is reduced, and wherein when the absolute value of the first pressure measured by the first pressure sensor is less than the first pressure set value, the rotation speed of the first rotation module is increased.

The gas control system for semiconductor equipment according to some embodiments further comprises a second pressure sensor measuring a second pressure of the gas passing through the sub-pipe, wherein the second energy controller includes a second rotation module capable of rotating, wherein when an absolute value of the second pressure measured by the second pressure sensor is greater than a second set value, a rotation speed of the second rotation module is reduced, and wherein when the absolute value of the second pressure measured by the second pressure sensor is less than the second set value, the rotation speed of the second rotation module is increased.

In some embodiments, wherein the first pressure remains constant even if the rotation speed of the second rotation module is changed.

The gas control system for semiconductor equipment according to some embodiments comprises a plurality of process chambers in which semiconductor processes are performed, a plurality of exhaust pipes connected respectively to the plurality of process chambers and discharging gas used in the semiconductor processes performed in the plurality of process chambers, an inlet pipe connected to all of the plurality of exhaust pipes, an energy dissipating device connected to the inlet pipe to dissipate energy of the gas supplied through the inlet pipe, a sub-pipe through which the gas having passed through the energy dissipating device is discharged, a main pipe connected to the sub-pipe and an energy controller disposed in the sub-pipe to control energy of the gas passing through the sub-pipe, wherein the gas is supplied to the energy dissipating device through the plurality of exhaust pipes and the inlet pipe, wherein thereafter the gas is discharged to the outside through the sub-pipe and the main pipe, and wherein a ratio of a sum of cross-sectional areas of the plurality of exhaust pipes to a cross-sectional area of the sub-pipe at a connection portion between the main pipe and the sub-pipe is between 2 and 10.

Since the cross-sectional area reduction rate of the sub-pipe compared to the exhaust pipe is 50% to 90%, space efficiency is improved and a semiconductor production line with improved stability may be provided.

The gas control system for semiconductor equipment according to some embodiments comprises a process chamber in which a semiconductor process is performed, an exhaust pipe connected to the process chamber and through which gas used in the semiconductor process is discharged, an inlet pipe connected to the exhaust pipe, an energy dissipating device connected to the inlet pipe to dissipate energy of the gas supplied through the inlet pipe, a sub-pipe through which the gas having passed through the energy dissipating device is discharged, a main pipe connected to the sub-pipe, a velocity sensor that measures a flow velocity of the gas passing through the sub-pipe, a pressure sensor that measures a pressure of the gas passing through the sub-pipe and an energy controller disposed in the sub-pipe to control energy of the gas passing through the sub-pipe and including a rotation module capable of rotating, wherein the gas is supplied to the energy dissipating device through the exhaust pipe and the inlet pipe, wherein thereafter the gas is discharged to the outside through the sub-pipe and the main pipe, wherein the energy of the gas includes a pressure energy and a kinetic energy, wherein the kinetic energy of the gas is proportional to the flow velocity of the gas, wherein the pressure energy of the gas is proportional to the pressure of the gas, wherein the kinetic energy of the gas is calculated based on the flow velocity measured by the velocity sensor, wherein the pressure energy of the gas is calculated based on the pressure measured by the pressure sensor, wherein when a sum of the kinetic energy and the pressure energy of the gas exceeds a preset value, a rotation speed of the rotation module of the energy controller is reduced, and wherein when the sum of the kinetic energy and the pressure energy of the gas is less than the preset value, the rotation speed of the rotation module of the energy controller is increased.

Specific details of other embodiments are included in the specification and drawings.

### EFFECT OF INVENTION

The gas control system for semiconductor equipment according to the present invention includes a first energy controller, a second energy controller, and an energy dissipating device. First, the energy of the gas discharged from the semiconductor process chamber may be controlled to a constant level through the first energy controller.

Since the energy of the gas is controlled to be constant, the stability of the semiconductor process chamber may be improved.

In addition, the energy dissipating device of the present invention may include a scrubber. The energy dissipating device includes at least one scrubbing plate. A scrubbing hole penetrating the scrubbing plate is formed inside the scrubbing plate. As the gas ascends through the scrubbing hole, bubbles may be formed in a scrubbing solution flowing over an upper surface of the scrubbing plate.

As the bubbles are formed, the contact area between the scrubbing solution and the gas is increased. Because the contact area is increased, hydrophilic impurities contained in the gas may be more effectively dissolved into the scrubbing solution. Thus, gas from which contaminants (impurities) have been removed may be discharged to the outside of the semiconductor production line.

Further, as the gas ascends through the scrubbing holes in the energy dissipating device, the energy of the gas may be reduced. The energy of the gas that has passed through the energy dissipating device may be controlled to a constant level through the second energy controller. As a result, the gas may be safely transferred to a utility duct.

Moreover, by using the gas control system for semiconductor equipment according to the present invention, the number of semiconductor process chambers relative to the number of main pipes may be increased, thereby providing a semiconductor production line with improved spatial efficiency.

### BRIEF DESCRIPTION OF DRAWINGS

FIG. 1 is a drawing briefly explaining a gas control system for semiconductor equipment according to some embodiments of the present invention.
FIG. 2 is an exemplary cross-sectional view for explaining the energy dissipating device of FIG. 1.
FIG. 3 is an exemplary enlarged view of the R region of FIG. 2.
FIG. 4 is an exemplary enlarged view of the P region and Q region of FIG. 1.
FIG. 5 is an exemplary drawing for explaining a first energy controller of FIG. 1.
FIGS. 6 to 13 are drawings for explaining the gas control system for semiconductor equipment according to some other embodiments of the present invention.
FIG. 14 is drawing for explaining an operating method of a gas control system for semiconductor equipment according to some embodiments of the present invention.

### MODE OF INVENTION

Hereinafter, preferred embodiments of the present invention will be described in detail with reference to the accompanying drawings. The advantages and features of the present invention and the methods for achieving them will become apparent with reference to the embodiments described in detail below together with the accompanying drawings. However, the present invention is not limited to the embodiments described below, but may be implemented in various different forms, and these embodiments are provided only to make the invention of the present invention complete and to fully inform those skilled in the art of the scope of the invention, and the present invention is defined only by the scope of the claims. Like reference numerals refer to like elements throughout the specification.

In addition, the terminology used herein is for the purpose of describing embodiments, and is not intended to limit and/or restrict the disclosed invention. The singular expression includes the plural expression unless the context clearly indicates otherwise. In this specification, the terms "comprises", "include", or "has" and the like are intended to specify that a feature, number, step, operation, component, part, or combination thereof described in the specification is present, but do not exclude in advance the possibility of the presence or addition of one or more other features, numbers, steps, operations, components, parts, or combinations thereof.

In addition, terms including ordinal numbers such as "first", "second", etc. used in this specification may be used to describe various components, but the components are not limited by the terms, and the terms are used only for the purpose of distinguishing one component from another. For example, without departing from the scope of the present invention, the first component may be named the second component, and similarly, the second component may also be named the first component. The term "and/or" includes a combination of multiple related described items or any item among multiple related described items.

Meanwhile, the terms "front", "rear", "upper", "lower", "front", and "lower" used in the following description are defined based on the drawings, and the shape and position of each component are not limited by these terms.

The terms used in this specification are for describing embodiments and are not intended to limit the present invention. In this specification, the singular includes the plural unless specifically stated in the phrase. The terms "comprise" and/or "comprising" used in the specification do not exclude the presence or addition of one or more other components, steps, operations, and/or elements mentioned.

Unless otherwise defined, all terms (including technical and scientific terms) used in this specification may be used in a meaning that can be commonly understood by a person of ordinary skill in the art to which the present invention belongs. In addition, terms defined in commonly used dictionaries shall not be ideally or excessively interpreted unless explicitly specifically defined.

Hereinafter, embodiments of the present invention will be described in detail with reference to the attached drawings, and when describing with reference to the attached drawings, identical or corresponding components will be given the same reference numerals regardless of the drawing numbers, and redundant descriptions thereof will be omitted.

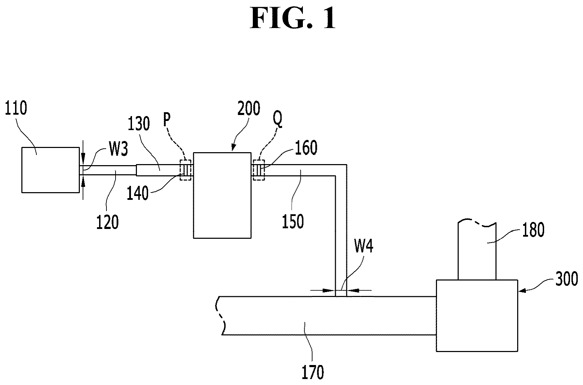

Hereinafter, first, a gas control system for semiconductor equipment according to some embodiments of the present invention will be described with reference to FIGS. 1 to 5.

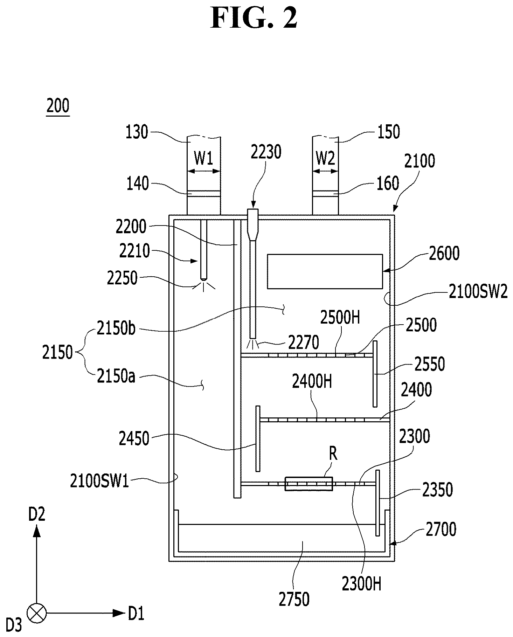

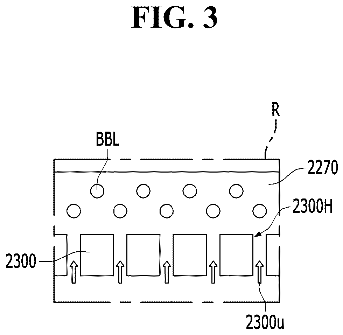

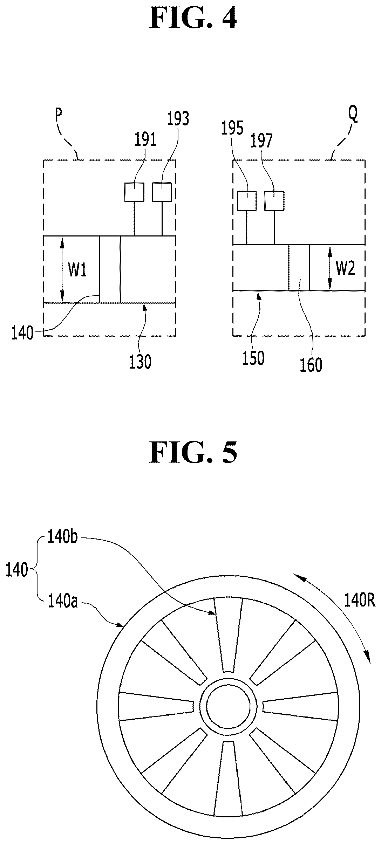

FIG. 1 is a drawing briefly explaining a gas control system for semiconductor equipment according to some embodiments of the present invention. FIG. 2 is an exemplary cross-sectional view for explaining the energy dissipating device of FIG. 1. FIG. 3 is an exemplary enlarged view of the R region of FIG. 2. FIG. 4 is an exemplary enlarged view of the P region and Q region of FIG. 1. FIG. 5 is an exemplary drawing for explaining a first energy controller of FIG. 1.

First, referring to FIG. 1, a gas control system for semiconductor equipment according to some embodiments comprises a process chamber 110, an energy dissipating device 200, an exhaust pipe 120, an inlet pipe 130, a sub-pipe 150, a main pipe 170, a utility pipe 180, a utility duct 300, a first energy controller, and a second energy controller 160.

The process chamber 110 may be a chamber in which a semiconductor process is performed. In order to manufacture a semiconductor device, various semiconductor processes must be performed on a wafer. For example, a film must be deposited on the wafer (deposition process), and the film must be etched (etching process) to form a pattern included in the semiconductor device. In addition, after the deposition process and/or the etching process are performed, a cleaning process must be performed to clean the wafer and/or the process chamber 110.

The deposition process may include, for example, physical vapor deposition (PVD), chemical vapor deposition (CVD), and/or atomic layer deposition (ALD). The etching process may include, for example, a dry etching process, a wet etching process, and/or an ashing process. The cleaning process may include, for example, a wet cleaning process, a dry cleaning process, and/or a vapor cleaning process.

In another embodiment, the deposition process, the etching process and/or the cleaning process may be performed simultaneously.

When various semiconductor processes are performed in the process chamber 110, by-products may be generated. The by-products must be discharged to the outside of the semiconductor production line through multiple pipes. At this time, the pressure, energy, and the like applied to the multiple pipes must be controlled to effectively manage the process chamber 110, the utility duct 300, and the like. If the by-products contain substances that are harmful to the human body, they must be necessarily removed before being discharged.

The exhaust pipe 120 may be connected to the process chamber 110. The exhaust pipe 120 may be interposed between the process chamber 110 and the inlet pipe 130. Gas used in the semiconductor process performed in the process chamber 110 may be discharged to the outside of the process chamber 110 through the exhaust pipe 120.

The exhaust pipe 120 may be connected to the inlet pipe 130. The inlet pipe 130 may be interposed between the exhaust pipe 120 and the energy dissipating device 200, which will be described later. In other words, the inlet pipe 130 may connect the exhaust pipe 120 and the energy dissipating device 200 to each other. The gas discharged from the process chamber 110 may be supplied to the energy dissipating device 200 through the exhaust pipe 120 and the inlet pipe 130.

In FIG. 1, although a third width W3 of the exhaust pipe 120 is shown as being less than width W1 of FIG. 2 of the inlet pipe 130, the technical scope of the present invention is not limited thereto. The third width W3 of the exhaust pipe 120 may be the same as the first width (W1 of FIG. 2) of the inlet pipe 130, or may be larger than the first width (W1 of FIG. 2) of the inlet pipe 130.

The energy dissipating device 200 may be disposed between the inlet pipe 130 and the sub-pipe 150. The gas is supplied to the energy dissipating device 200 through the inlet pipe 130. The gas having passed through the energy dissipating device 200 may be discharged to the outside of the energy dissipating device 200 through the sub-pipe 150.

In some embodiments, the gas may have energy. The energy may include pressure energy and kinetic energy. Although the energy may include other types of energy in addition to the pressure energy and the kinetic energy, for convenience of explanation, it is assumed that energies other than the pressure energy and the kinetic energy are zero.

After passing through the energy dissipating device 200, the energy of the gas may be reduced. That is, the energy dissipating device 200 may reduce the energy of the gas. A detailed description related thereto will be provided later.

The sub-pipe 150 may be connected to the energy dissipating device 200. The gas having passed through the energy dissipating device 200 may be discharged to the outside through the sub-pipe 150. The sub-pipe 150 may be interposed between the energy dissipating device 200 and the main pipe 170.

The main pipe 170 may be interposed between the sub-pipe 150 and the utility duct 300. The main pipe 170 may be connected to the sub-pipe 150. The gas having passed through the sub-pipe 150 may be supplied to the main pipe 170. The main pipe 170 may be provided in a floor space of the semiconductor production line.

The utility duct 300 may be connected to the main pipe 170. The utility duct 300 may provide pressure to the main pipe 170. The gas may be moved using the pressure provided by the utility duct 300. The gas having passed through the utility duct 300 may be discharged to the outside of the semiconductor production line through the utility pipe 180.

In some embodiments, the energy dissipating device 200 may include a scrubber. When the semiconductor process is performed in the process chamber 110, various by-products may be generated. The by-products may contain substances that are harmful to the human body, and if the by-products contain such harmful substances, they must be necessarily removed before being discharged.

The scrubber may be used to remove substances that are harmful to the human body from the by-products generated in the process chamber 110. That is, the energy dissipating device 200 may scrub impurities contained in the gas while simultaneously reducing the energy of the gas. The impurities may include hydrophilic substances.

However, the technical scope of the present invention is not limited thereto. The energy dissipating device 200 may, of course, have a configuration other than the scrubber.

Referring to FIGS. 2 and 3, the energy dissipating device 200 according to some embodiments of the present invention may include a scrubbing chamber 2100, a separating wall 2200, a first scrubbing plate 2300, a second scrubbing plate 2400, a third scrubbing plate 2500, a spray nozzle 2210, a solution supply nozzle 2230, and a demister 2600.

First, the scrubbing chamber 2100 may be provided. The scrubbing chamber 2100 may be an outer housing of the energy dissipating device 200. The gas may be supplied into the scrubbing chamber 2100. The gas may contain the impurities.

For example, the gas may be supplied into the scrubbing chamber 2100 through the inlet pipe 130. The inlet pipe 130 may be formed in an upper wall of the scrubbing chamber 2100 or may be formed in a side wall of the scrubbing chamber 2100. In addition, the inlet pipe 130 may be formed in an upper part of the side wall or may be formed in a lower part of the side wall of the scrubbing chamber 2100.

In the scrubbing chamber 2100, the impurities contained in the gas may be dissolved into a scrubbing solution. The scrubbing chamber 2100 may define a scrubbing space 2150. The scrubbing space 2150 may be a space in which the scrubbing process is performed, wherein the impurities contained in the gas are dissolved into the scrubbing solution.

In some embodiments, the scrubbing space 2150 may include a first sub-space 2150a and a second sub-space 2150b. The first sub-space 2150a and the second sub-space 2150b may be separated by the separating wall 2200. The first sub-space 2150a and the second sub-space 2150b may be defined by the separating wall 2200.

The separating wall 2200 may be disposed inside the scrubbing chamber 2100. In some embodiments, the separating wall 2200 may be attached to the upper wall of the scrubbing chamber 2100. The separating wall 2200 may extend from the upper wall of the scrubbing chamber 2100 in a second direction D2. The second direction D2 may be a direction perpendicular to the ground.

In some embodiments, the separating wall 2200 may have a bar shape in a planar view. The separating wall 2200 may extend in a third direction D3 in a planar view. One end of the separating wall 2200 may be connected in contact with a third inner side wall of the scrubbing chamber 2100, and the other end of the separating wall 2200 may be connected in contact with a fourth inner side wall of the scrubbing chamber 2100. Although the separating wall 2200 may include a long side extending in the third direction D3 and a short side extending in a first direction D1, the technical scope of the present invention is not limited thereto.

In some embodiments, the scrubbing chamber 2100 may include a first inner side wall 2100SW1, a second inner side wall 2100SW2, the third inner side wall, and the fourth inner side wall.

The first inner side wall 2100SW1 of the scrubbing chamber 2100 may face the separating wall 2200. The second inner side wall 2100SW2 of the scrubbing chamber 2100 may face the first inner side wall 2100SW1 in the first direction D1. The third inner side wall and the fourth inner side wall may face each other in the third direction D3 and may intersect the first inner side wall 2100SW1 and the second inner side wall 2100SW2, respectively.

The separating wall 2200 may define the first sub-space 2150a and the second sub-space 2150b. The separating wall 2200 may divide the scrubbing space 2150 into the first sub-space 2150a and the second sub-space 2150b.

A first scrubbing process may be performed in the first sub-space 2150a. A second scrubbing process may be performed in the second sub-space 2150b. The first scrubbing process may be a process in which a portion of impurities is dissolved into a first scrubbing solution 2250. The second scrubbing process may be a process in which another portion of impurities is dissolved into a second scrubbing solution 2270.

In the present specification, the first direction D1 and the third direction D3 may intersect each other. The first direction D1 and the second direction D2 may intersect each other. The second direction D2 and the third direction D3 may intersect each other. That is, in the present specification, the first direction D1, the second direction D2, and the third direction D3 may be substantially perpendicular to one another.

The first scrubbing plate 2300, the second scrubbing plate 2400, and the third scrubbing plate 2500 may be disposed inside the scrubbing space 2150. Specifically, the first scrubbing plate 2300, the second scrubbing plate 2400, and the third scrubbing plate 2500 may be disposed inside the second sub-space 2150b.

In FIG. 2, the energy dissipating device 200 of the present invention is illustrated as including three scrubbing plates, however, the technical scope of the present invention is not limited thereto. The energy dissipating device 200 according to some embodiments of the present invention may include one or more scrubbing plates. That is, one scrubbing plate, two scrubbing plates, or four or more scrubbing plates may be disposed inside the second sub-space 2150b.

The first scrubbing plate 2300 may be disposed at the lowermost position among the scrubbing plates disposed inside the second sub-space 2150b. One end of the first scrubbing plate 2300 may be fixedly connected to the separating wall 2200. Specifically, one end of the first scrubbing plate 2300 may be fixedly connected to a side wall of the separating wall 2200 facing the second sub-space 2150b. The first scrubbing plate 2300 may extend in the first direction D1 while being connected to and intersecting the separating wall 2200. More specifically, the first scrubbing plate 2300 may be placed on a plane defined by the first direction D1 and the third direction D3.

In some embodiments, another portion of the first scrubbing plate 2300 may be fixedly connected to inner side walls of the scrubbing chamber 2100. Specifically, the first scrubbing plate 2300 may be connected to the separating wall 2200, the third inner side wall of the scrubbing chamber 2100, and the fourth inner side wall of the scrubbing chamber 2100 in the second sub-space 2150b.

However, the first scrubbing plate 2300 may not be fixedly connected to the second inner side wall 2100SW2 of the scrubbing chamber 2100. The first scrubbing plate 2300 may be spaced apart from the second inner side wall 2100SW2 of the scrubbing chamber 2100 in the first direction D1. A space between the other end of the first scrubbing plate 2300 and the second inner side wall 2100SW2 of the scrubbing chamber 2100 may serve as a space through which a second scrubbing solution 2270, which will be described later, flows downward (e.g., in a second direction D2).

The energy dissipating device 200 according to some embodiments may further include a first scrubbing hole 2300H and a first scrubbing wall 2350.

The first scrubbing hole 2300H may be formed inside the first scrubbing plate 2300. The first scrubbing hole 2300H may extend from a lower surface of the first scrubbing plate 2300 to an upper surface of the first scrubbing plate 2300. That is, the first scrubbing hole 2300H may penetrate the first scrubbing plate 2300 in the second direction D2. The gas may ascend in the second direction D2 through the first scrubbing hole 2300H (see reference numeral 2300u).

The upper surface of the first scrubbing plate 2300 may face the demister 2600, which will be described later, and the lower surface of the first scrubbing plate 2300 may face the scrubbing solution storage tank 2700, which will be described later.

The first scrubbing wall 2350 may be attached to the other end of the first scrubbing plate 2300. The first scrubbing wall 2350 may be interposed between the first scrubbing plate 2300 and the second inner side wall 2100SW2 of the scrubbing chamber 2100. The first scrubbing wall 2350 may extend in the second direction D2. In some embodiments, a portion of the first scrubbing wall 2350 may protrude in the second direction D2 from the upper surface of the first scrubbing plate 2300, and another portion of the first scrubbing wall 2350 may protrude in the second direction D2 from the lower surface of the first scrubbing plate 2300.

A length in the second direction D2 of a portion of the first scrubbing wall 2350 protruding from the upper surface of the first scrubbing plate 2300 may be less than a length in the second direction D2 of a portion protruding from the lower surface of the first scrubbing plate 2300, however, the technical scope of the present invention is not limited thereto.

In some embodiments, at least a portion of the part of the first scrubbing wall 2350 protruding in the second direction D2 from the lower surface of the first scrubbing plate 2300 may be disposed in a scrubbing solution 2750, in which impurities, which will be described later, are dissolved, however, the technical scope of the present invention is not limited thereto.

The second scrubbing plate 2400 may be disposed on the first scrubbing plate 2300. Specifically, the second scrubbing plate 2400 may be disposed on the upper surface of the first scrubbing plate 2300. One end of the second scrubbing plate 2400 may be fixedly connected to the second inner side wall 2100SW2 of the scrubbing chamber 2100. The second scrubbing plate 2400 may extend in the first direction D1 while being connected to and intersecting the second inner side wall 2100SW2 of the scrubbing chamber 2100. More specifically, the second scrubbing plate 2400 may be placed on a plane defined by the first direction D1 and the third direction D3.

Similarly, the second scrubbing plate 2400 may be fixedly connected to the third inner side wall and the fourth inner side wall of the scrubbing chamber 2100. However, the other end of the second scrubbing plate 2400 may not be fixedly connected to the separating wall 2200. The other end of the second scrubbing plate 2400 may be spaced apart from the separating wall 2200 in the first direction D1. A space between the other end of the second scrubbing plate 2400 and the separating wall 2200 may serve as a space through which a second scrubbing solution 2270, which will be described later, flows downward (e.g., in the second direction D2).

The energy dissipating device 200 according to some embodiments may further include a second scrubbing hole 2400H and a second scrubbing wall 2450.

The second scrubbing hole 2400H may be formed inside the second scrubbing plate 2400. The second scrubbing hole 2400H may extend from a lower surface of the second scrubbing plate 2400 to an upper surface of the second scrubbing plate 2400. The second scrubbing hole 2400H may penetrate the second scrubbing plate 2400 in the second direction D2. The gas may ascend in the second direction D2 through the second scrubbing hole 2400H.

The upper surface of the second scrubbing plate 2400 may face the demister 2600, which will be described later, and the lower surface of the second scrubbing plate 2400 may face the upper surface of the first scrubbing plate 2300.

The second scrubbing wall 2450 may be attached to the other end of the second scrubbing plate 2400. The second scrubbing wall 2450 may be interposed between the second scrubbing plate 2400 and the separating wall 2200. The second scrubbing wall 2450 may extend in the second direction D2. In some embodiments, a portion of the second scrubbing wall 2450 may protrude in the second direction D2 from the upper surface of the second scrubbing plate 2400, and another portion of the second scrubbing wall 2450 may protrude in the second direction D2 from the lower surface of the second scrubbing plate 2400.

A length in the second direction D2 of a portion of the second scrubbing wall 2450 protruding from the upper surface of the second scrubbing plate 2400 may be less than a length in the second direction D2 of a portion protruding from the lower surface of the second scrubbing plate 2400, however, the technical scope of the present invention is not limited thereto.

In some embodiments, the first scrubbing plate 2300 and the second scrubbing plate 2400 may not be completely overlapped in the second direction D2. The first scrubbing plate 2300 and the second scrubbing plate 2400 may be arranged in a zigzag configuration. Accordingly, the second scrubbing solution 2270 flowing downward beyond the second scrubbing wall 2450 may be discharged onto the upper surface of the first scrubbing plate 2300. In other words, centers of the first scrubbing plate 2300 and the second scrubbing plate 2400 may be offset from each other.

The third scrubbing plate 2500 may be disposed on the second scrubbing plate 2400. Specifically, the third scrubbing plate 2500 may be disposed on the upper surface of the second scrubbing plate 2400. One end of the third scrubbing plate 2500 may be fixedly connected to the separating wall 2200.

Specifically, one end of the third scrubbing plate 2500 may be fixedly connected to a side wall of the separating wall 2200 facing the second sub-space 2150b. The third scrubbing plate 2500 may extend in the first direction D1 while being connected to and intersecting the separating wall 2200. More specifically, the third scrubbing plate 2500 may be placed on a plane defined by the first direction D1 and the third direction D3. Similarly, the third scrubbing plate 2500 may be fixedly connected to the third inner side wall and the fourth inner side wall of the scrubbing chamber 2100.

However, the other end of the third scrubbing plate 2500 may not be fixedly connected to the second inner side wall 2100SW2 of the scrubbing chamber 2100. The other end of the third scrubbing plate 2500 may be spaced apart from the second inner side wall 2100SW2 of the scrubbing chamber 2100 in the first direction D1. A space between the other end of the third scrubbing plate 2500 and the second inner side wall 2100SW2 of the scrubbing chamber 2100 may serve as a space through which a second scrubbing solution 2270, which will be described later, flows downward (e.g., in the second direction D2).

The energy dissipating device 200 according to some embodiments may further include a third scrubbing hole 2500H and a third scrubbing wall 2550.

The third scrubbing hole 2500H may be formed inside the third scrubbing plate 2500. The third scrubbing hole 2500H may extend from a lower surface of the third scrubbing plate 2500 to an upper surface of the third scrubbing plate 2500. The third scrubbing hole 2500H may penetrate the third scrubbing plate 2500 in the second direction D2. The gas may ascend in the second direction D2 through the third scrubbing hole 2500H.

The upper surface of the third scrubbing plate 2500 may face the demister 2600, which will be described later, and the lower surface of the third scrubbing plate 2500 may face the upper surface of the second scrubbing plate 2400.

The third scrubbing wall 2550 may be attached to the other end of the third scrubbing plate 2500. The third scrubbing wall 2550 may be interposed between the third scrubbing plate 2500 and the second inner side wall 2100SW2 of the scrubbing chamber 2100. The third scrubbing wall 2550 may extend in the second direction D2.

In some embodiments, a portion of the third scrubbing wall 2550 may protrude in the second direction D2 from the upper surface of the third scrubbing plate 2500. Another portion of the third scrubbing wall 2550 may protrude in the second direction D2 from the lower surface of the third scrubbing plate 2500.

A length in the second direction D2 of a portion of the third scrubbing wall 2550 protruding from the upper surface of the third scrubbing plate 2500 may be less than a length in the second direction D2 of a portion protruding from the lower surface of the third scrubbing plate 2500, however, the technical scope of the present invention is not limited thereto.

In some embodiments, the third scrubbing plate 2500 and the second scrubbing plate 2400 may not be completely overlapped in the second direction D2. The third scrubbing plate 2500 and the second scrubbing plate 2400 may be arranged in a zigzag configuration. The second scrubbing solution 2270 flowing downward beyond the third scrubbing wall 2550 may be discharged onto the upper surface of the second scrubbing plate 2400. In other words, centers of the third scrubbing plate 2500 and the second scrubbing plate 2400 may be offset from each other.

However, the third scrubbing plate 2500 and the first scrubbing plate 2300 may be completely overlapped in the second direction D2. That is, centers of the third scrubbing plate 2500 and the first scrubbing plate 2300 may be overlapped in the second direction D2.

In some embodiments, the first to third scrubbing holes 2300H, 2400H, and 2500H may be completely overlapped in the second direction D2. However, the technical scope of the present invention is not limited thereto. The first to third scrubbing holes 2300H, 2400H, and 2500H may not be completely overlapped in the second direction D2, or only partially overlapped.

In some embodiments, the second scrubbing solution 2270 may be water. However, the technical scope of the present invention is not limited thereto.

The second scrubbing solution 2270 may flow toward the third scrubbing wall 2550 on the upper surface of the third scrubbing plate 2500 after being discharged onto the upper surface of the third scrubbing plate 2500 during the second scrubbing process. At this time, the second scrubbing solution 2270 does not flow downward through the third scrubbing hole 2500H. The second scrubbing solution 2270 may flow downward beyond the third scrubbing wall 2550 to the lower part of the scrubbing chamber 2100.

The second scrubbing solution 2270 having flowed beyond the third scrubbing wall 2550 is discharged again onto the upper surface of the second scrubbing plate 2400. The second scrubbing solution 2270 may flow toward the second scrubbing wall 2450 on the upper surface of the second scrubbing plate 2400 during the second scrubbing process.

The second scrubbing solution 2270 placed on the upper surface of the second scrubbing plate 2400 does not flow downward through the second scrubbing hole 2400H. The second scrubbing solution 2270 may flow downward beyond the second scrubbing wall 2450 to the lower part of the scrubbing chamber 2100.

Similarly, the second scrubbing solution 2270 having flowed beyond the second scrubbing wall 2450 is discharged again onto the upper surface of the first scrubbing plate 2300. The second scrubbing solution 2270 may flow toward the first scrubbing wall 2350 on the upper surface of the first scrubbing plate 2300 during the second scrubbing process.

At this time, the second scrubbing solution 2270 does not flow downward through the first scrubbing hole 2300H. The second scrubbing solution 2270 may flow downward beyond the first scrubbing wall 2350 to the lower part of the scrubbing chamber 2100.

Finally, the second scrubbing solution 2270 having flowed beyond the first scrubbing wall 2350 may be stored in the scrubbing solution storage tank 2700 provided at the lower part of the scrubbing chamber 2100. A scrubbing solution 2750, in which impurities are dissolved, may be stored in the scrubbing solution storage tank 2700. For example, the scrubbing solution 2750, in which impurities are dissolved, may be a solution in which a hydrophilic gas is dissolved into the second scrubbing solution 2270.

In some embodiments, the hydrophilic gas may be IPA (isopropyl alcohol) and/or ammonia, however, the technical scope of the present invention is not limited thereto.

The demister 2600 may be disposed at the upper part of the scrubbing chamber 2100. The demister 2600 may be used to remove moisture from gas after the first scrubbing process and the second scrubbing process have been performed. After the first scrubbing process and the second scrubbing process have been performed, gas from which impurities have been removed may be provided. That is, moisture may be removed from gas, from which impurities have been removed, after the first scrubbing process and the second scrubbing process have been performed by using the demister 2600. The gas filtered through the demister 2600 may be discharged to the outside of the energy dissipating device 200.

When the energy dissipating device 200 according to some embodiments is used, a gas harmful to the human body (e.g., impurities) may be dissolved into the scrubbing solution. Accordingly, the gas harmful to the human body generated from by-products after various semiconductor processes have been performed may be removed and discharged to the outside of the energy dissipating device 200.

In some embodiments, the first sub-space 2150a may be defined by the first inner side wall 2100SW1 of the scrubbing chamber 2100 and the separating wall 2200. For example, the first sub-space 2150a may be defined by the first inner side wall 2100SW1, the third inner side wall of the scrubbing chamber 2100, the fourth inner side wall of the scrubbing chamber 2100, and the separating wall 2200.

The first scrubbing process may be performed in the first sub-space 2150a.

Specifically, the first scrubbing solution 2250 may be provided into an interior of the scrubbing chamber 2100 through the spray nozzle 2210. The first scrubbing solution 2250 may be provided into the first sub-space 2150a through the spray nozzle 2210.

The first scrubbing solution 2250 may be provided from an upper part toward a lower part of the first sub-space 2150a, and at least a portion of impurities contained in gas flowing from the upper part toward the lower part of the first sub-space 2150a may be dissolved into the first scrubbing solution 2250. In some embodiments, the first scrubbing solution 2250 may include water, however, the technical scope of the present invention is not limited thereto.

In some embodiments, the spray nozzle 2210 may be a spray nozzle. The spray nozzle 2210 may supply a first scrubbing solution 2250 having fine particles into the first sub-space 2150a. Accordingly, a contact area between the first scrubbing solution 2250 and gas may be increased. As a result, a scrubber with improved scrubbing efficiency may be provided.

The spray nozzle 2210 may be installed at the upper part of the scrubbing chamber 2100. Although not shown, the spray nozzle 2210 may be connected to a pipe installed outside the scrubbing chamber 2100.

In some embodiments, the inlet pipe 130 may be installed at one side of the first sub-space 2150a. The gas introduced into the energy dissipating device 200 may be introduced into the interior of the scrubbing chamber 2100 through the inlet pipe 130. Since the inlet pipe 130 is connected to the exhaust pipe 120 and the exhaust pipe 120 is connected to the process chamber 110, the gas introduced into the energy dissipating device 200 may be provided from the process chamber 110.

When the energy dissipating device 200 according to some embodiments is used, the contact area between the scrubbing solution and the gas may be increased. Specifically, the contact area between the scrubbing solution and the gas may be increased by forming bubbles in the scrubbing solution.

In addition, energy of gas passing through the energy dissipating device 200 may be dissipated. Since the energy of the gas is dissipated, the energy of the gas passing through the sub-pipe 150 and the main pipe 170 may be more easily controlled.

For example, as shown in FIG. 3, the gas may ascend in the second direction D2 through the first scrubbing hole 2300H (see reference numeral 2300u).

After the gas ascends through the first scrubbing hole 2300H, bubbles BBL may be formed on the upper surface of the first scrubbing plate 2300. The bubbles BBL may be formed inside the second scrubbing solution 2270. The bubbles BBL may be air bubbles generated due to pressure caused by the gas attempting to ascend in the second direction D2 inside the second scrubbing solution 2270. When the gas ascends through the first scrubbing hole 2300H, the energy of the gas may be reduced. Pressure energy of the gas may be reduced, and kinetic energy of the gas may also be reduced.

At a portion where the bubbles BBL and the second scrubbing solution 2270 are in contact with each other, the impurities contained in the gas may be dissolved into the second scrubbing solution 2270.

Subsequently, the gas may ascend in the second direction D2 by ascending through the second scrubbing hole 2400H after ascending through the first scrubbing hole 2300H.

After the gas ascends through the second scrubbing hole 2400H, another bubble may be formed on the upper surface of the second scrubbing plate 2400. The other bubble may be formed inside the second scrubbing solution 2270. The other bubble may be an air bubble generated due to pressure caused by the gas attempting to ascend in the second direction D2 inside the second scrubbing solution 2270. When the gas ascends through the second scrubbing hole 2400H, the energy of the gas may be reduced. The pressure energy of the gas may be reduced, and the kinetic energy of the gas may also be reduced.

At a portion where the other bubble and the second scrubbing solution 2270 are in contact with each other, the impurities contained in the gas may be dissolved into the second scrubbing solution 2270.

Similarly, the gas may ascend in the second direction D2 by ascending through the third scrubbing hole 2500H after ascending through the second scrubbing hole 2400H. After the gas ascends through the third scrubbing hole 2500H, yet another bubble may be formed on the upper surface of the third scrubbing plate 2500.

After the gas ascends through the third scrubbing hole 2500H, the yet another bubble may be formed on an upper surface of the third scrubbing plate 2500. The yet another bubble may be formed inside the second scrubbing solution 2270. The yet another bubble may be an air bubble generated due to pressure caused by the gas attempting to ascend in the second direction D2 inside the second scrubbing solution 2270. When the gas ascends through the third scrubbing hole 2500H, the energy of the gas may be reduced. The pressure energy of the gas may be reduced, and the kinetic energy of the gas may also be reduced.

At a portion where the yet another bubble and the second scrubbing solution 2270 are in contact with each other, the impurities contained in the gas may be dissolved into the second scrubbing solution 2270.

When the bubbles are formed in the second scrubbing solution 2270, the contact area between the gas and the scrubbing solution may be increased. Accordingly, the scrubber with improved scrubbing efficiency may be provided. In addition, each time the gas passes through the scrubbing holes 2300H, 2400H, and 2500H, the energy of the gas may be reduced, and when the energy of the gas is reduced, the energy of the gas passing through the sub-pipe 150 and the main pipe 170 may be more easily controlled.

Referring to FIG. 4, the first energy controller 140 may be disposed inside the inlet pipe 130. The second energy controller 160 may be disposed inside the sub-pipe 150. The first energy controller 140 may control energy of the gas inside the inlet pipe 130 to a constant value.

For example, the gas may have a first energy inside the inlet pipe 130. The first energy may include a first pressure energy and a first kinetic energy. The first pressure energy may be proportional to a first pressure of the gas. The first pressure energy may be proportional to a first static pressure of the gas. The first kinetic energy may be proportional to a first velocity of the gas. The first kinetic energy may be proportional to a first dynamic pressure of the gas.

That is, the gas may have the first pressure and the first velocity inside the inlet pipe 130, and the first energy of the gas may be defined by the first pressure and the first velocity.

In addition, the gas may have a second energy inside the sub-pipe 150. The second energy may include a second pressure energy and a second kinetic energy. The second pressure energy may be proportional to a second pressure of the gas. The second pressure energy may be proportional to a second static pressure of the gas. The second kinetic energy may be proportional to a second velocity of the gas. The second kinetic energy may be proportional to a second dynamic pressure of the gas.

That is, the gas may have the second pressure and the second velocity inside the inlet pipe 130, and the second energy of the gas may be defined by the second pressure and the second velocity.

The first energy controller 140 may control the first energy to a constant value inside the inlet pipe 130. For example, the first energy controller 140 may control first pressure energy of the gas to a constant value. The constant value may be between 400 Pa and 800 Pa. Preferably, the constant value may be between 600 Pa and 700 Pa. However, the technical scope of the present invention is not limited thereto. At this time, the first velocity of the gas passing through the inlet pipe 130 may be maintained constant.

The second energy controller 160 may control the second energy to a constant value inside the sub-pipe 150.

Referring to FIG. 5, the first energy controller 140 may include a first housing 140a and a first rotation module 140b.

The first housing 140a may be fixed by being connected to an inner side wall of the inlet pipe 130. Unlike what is illustrated, the first energy controller 140 may not include a housing. The first rotation module 140b may be rotatable. The first rotation module 140b may rotate in a clockwise direction or a counterclockwise direction (see reference numeral 140R). By adjusting a rotation speed of the first rotation module 140b, the first energy may be controlled to a constant value.

The second energy controller 160 may include a second housing and a second rotation module. The second housing may be fixed by being connected to an inner side wall of the sub-pipe 150. The second rotation module may be rotatable. The second rotation module may rotate in a clockwise direction or a counterclockwise direction. By adjusting a rotation speed of the second rotation module, the second energy may be controlled to a constant value. The second energy controller 160 may be substantially the same as the first energy controller 140.

In some embodiments, the first kinetic energy may be less than the second kinetic energy. In other words, the first velocity of the gas passing through the inlet pipe 130 may be less than the second velocity of the gas passing through the sub-pipe 150. In other words, the first dynamic pressure of the gas passing through the inlet pipe 130 may be less than the second dynamic pressure of the gas passing through the sub-pipe 150. This may be because a first width W1 of the inlet pipe 130 may be greater than a second width W2 of the sub-pipe 150.

The semiconductor gas control system according to some embodiments may further include a first pressure sensor 191, a first velocity sensor 193, a second pressure sensor 195, and a second velocity sensor 197.

The first pressure sensor 191 may measure the first pressure of the gas passing through the inlet pipe 130. The first pressure sensor 191 may measure the first static pressure of the gas passing through the inlet pipe 130. The first pressure sensor 191 may be disposed at a rear end of the first energy controller 140. The rear end of the first energy controller 140 may be between the first energy controller 140 and the energy dissipating device 200. A front end of the first energy controller 140 may be between the first energy controller 140 and the exhaust pipe 120.

In some embodiments, the rear end of the first energy controller 140 may be under a negative pressure, and the front end of the first energy controller 140 may be under a positive pressure. However, an absolute value of a pressure measured at the rear end of the first energy controller 140 and an absolute value of a pressure measured at the front end of the first energy controller 140 may be substantially the same.

In some embodiments, when an absolute value of the first pressure measured by the first pressure sensor 191 is greater than a first pressure set value, a rotation speed of the first rotation module 140b of the first energy controller 140 may be decreased. When an absolute value of the first static pressure measured by the first pressure sensor 191 is greater than the first pressure set value, the rotation speed of the first rotation module 140b of the first energy controller 140 may be decreased.

That is, when an absolute value of the first pressure measured by the first pressure sensor 191 is greater than the first pressure set value, an RPM (rotations per minute) of the first rotation module 140b may be decreased. The first pressure set value may be between 500 Pa and 800 Pa, but the technical scope of the present invention is not limited thereto.

This may be because an absolute value of the first pressure or an absolute value of the first static pressure of the gas passing through the inlet pipe 130 may be decreased when the rotation speed of the first rotation module 140b is decreased.

In some embodiments, as an absolute value of the first pressure becomes greater than the first pressure set value, an RPM (rotations per minute) of the first rotation module 140b may sharply decrease. This may be to more rapidly adjust the absolute value of the first pressure to be the same as the first pressure set value as the difference between the absolute value of the first pressure and the first pressure set value becomes larger. Accordingly, stability of the process chamber 110 connected to the inlet pipe 130 may be improved.

Conversely, when an absolute value of the first pressure measured by the first pressure sensor 191 is less than the first pressure set value, the rotation speed of the first rotation module 140b may be increased. That is, when the absolute value of the first pressure measured by the first pressure sensor 191 is less than the first pressure set value, an RPM (rotations per minute) of the first rotation module 140b may be increased.

This may be because an absolute value of the first pressure of the gas passing through the inlet pipe 130 may be increased when the rotation speed of the first rotation module 140b is increased.

In some embodiments, the first velocity sensor 193 may measure the first velocity of the gas passing through the inlet pipe 130. The first velocity sensor 193 may measure the first dynamic pressure of the gas passing through the inlet pipe 130.

In some embodiments, when an absolute value of the first velocity measured by the first velocity sensor 193 is greater than a second velocity set value, the rotation speed of the first rotation module 140b of the first energy controller 140 may be decreased. When an absolute value of the first dynamic pressure measured by the first velocity sensor 193 is greater than a first velocity set value, the rotation speed of the first rotation module 140b of the first energy controller 140 may be decreased.

In another example, when an absolute value of the first velocity measured by the first velocity sensor 193 is less than the second velocity set value, the rotation speed of the first rotation module 140b of the first energy controller 140 may be increased. When an absolute value of the first dynamic pressure measured by the first velocity sensor 193 is less than the first velocity set value, the rotation speed of the first rotation module 140b of the first energy controller 140 may be increased.

In some embodiments, the first energy of the gas passing through the inlet pipe 130 may be calculated by using the first pressure sensor 191 and the first velocity sensor 193. When a magnitude of the first energy is greater than a first energy set value, the rotation speed of the first rotation module 140b of the first energy controller 140 may be decreased. Conversely, when the magnitude of the first energy is less than the first energy set value, the rotation speed of the first rotation module 140b of the first energy controller 140 may be increased.

The first energy set value may be the energy of the gas when a pressure of the gas is the first pressure set value, and a velocity of the gas is the first velocity set value.

The second pressure sensor 195 may measure the second pressure of the gas passing through the sub-pipe 150. The second pressure sensor 195 may measure the second static pressure of the gas passing through the sub-pipe 150. The second pressure sensor 195 may be disposed at a front end of the second energy controller 160. The front end of the second energy controller 160 may be between the second energy controller 160 and the energy dissipating device 200. The front end of the second energy controller 160 may be between the second energy controller 160 and the main pipe 170.

In some embodiments, the rear end of the second energy controller 160 may be under a negative pressure, and the front end of the second energy controller 160 may be under a positive pressure. However, an absolute value of a pressure measured at the rear end of the second energy controller 160 and an absolute value of a pressure measured at the front end of the second energy controller 160 may be substantially the same.

In some embodiments, when an absolute value of the second pressure measured by the second pressure sensor 195 is greater than a second pressure set value, the rotation speed of a second rotation module of the second energy controller 160 may be decreased. When an absolute value of the second static pressure measured by the second pressure sensor 195 is greater than the second pressure set value, the rotation speed of the second rotation module of the second energy controller 160 may be decreased.

That is, when an absolute value of the second pressure measured by the second pressure sensor 195 is greater than the second pressure set value, an RPM (rotations per minute) of the second rotation module may be decreased. The second pressure set value may be between 500 Pa and 800 Pa, but the technical scope of the present invention is not limited thereto.

This may be because an absolute value of the second pressure of the gas passing through the sub-pipe 150 may be decreased when the rotation speed of the second rotation module is decreased.

In some embodiments, as an absolute value of the second pressure becomes greater than the second pressure set value, an RPM of the second rotation module may sharply decrease. This may be to more rapidly adjust the absolute value of the second pressure to be the same as the second pressure set value as the difference between the absolute value of the second pressure and the second pressure set value becomes larger. Accordingly, stability of the sub-pipe 150 and the main pipe 170 may be improved.

Conversely, when an absolute value of the second pressure measured by the second pressure sensor 195 is less than the second pressure set value, the rotation speed of the second rotation module may be increased. That is, when the absolute value of the second pressure measured by the second pressure sensor 195 is less than the second pressure set value, an RPM (rotations per minute) of the second rotation module may be increased.

This may be because an absolute value of the second pressure of the gas passing through the sub-pipe 150 may be increased when the rotation speed of the second rotation module is increased.

In some embodiments, the second velocity sensor 197 may measure the second velocity of the gas passing through the sub-pipe 150. The second velocity sensor 197 may measure the second dynamic pressure of the gas passing through the sub-pipe 150.

In some embodiments, when an absolute value of the second velocity measured by the second velocity sensor 197 is greater than a second velocity set value, the rotation speed of the second rotation module of the second energy controller 160 may be decreased. When an absolute value of the second dynamic pressure measured by the second velocity sensor 197 is greater than a second velocity set value, the rotation speed of the second rotation module of the second energy controller 160 may be decreased.

In another example, when an absolute value of the second velocity measured by the second velocity sensor 197 is less than a second velocity set value, the rotation speed of the second rotation module of the second energy controller 160 may be increased. When an absolute value of the second dynamic pressure measured by the second velocity sensor 197 is less than the second velocity set value, the rotation speed of the second rotation module of the second energy controller 160 may be increased.

In some embodiments, the second energy of the gas passing through the sub-pipe 150 may be calculated by using the second pressure sensor 195 and the second velocity sensor 197. When a magnitude of the second energy is greater than a second energy set value, the rotation speed of the second rotation module of the second energy controller 160 may be decreased. Conversely, when the magnitude of the second energy is less than the second energy set value, the rotation speed of the second rotation module of the second energy controller 160 may be increased.

The second energy set value may be energy of the gas when a pressure of the gas is the second pressure set value, and a velocity of the gas is the second velocity set value.

In some embodiments, even if the rotation speed of the second rotation module changes, the first pressure and the first velocity of the gas passing through the inlet pipe 130 may remain constant. In other words, the first static pressure and the first dynamic pressure of the gas passing through the inlet pipe 130 may remain constant.

In addition, even if the rotation speed of the first rotation module 140b changes, the second pressure and the second velocity of the gas passing through the sub-pipe 150 may remain constant. In other words, the second static pressure and the second dynamic pressure of the gas passing through the sub-pipe 150 may remain constant.

In some embodiments, the sub-pipe 150 may have a fourth width W4 at a portion where the sub-pipe 150 is connected to the main pipe 170.

In some embodiments, at a portion where the sub-pipe 150 is connected to the main pipe 170, a ratio of a cross-sectional area of the exhaust pipe 120 to a cross-sectional area of the sub-pipe 150 may be between 2 and 10. That is, the cross-sectional area of the sub-pipe 150 may be reduced by 50% to 90% compared to the cross-sectional area of the exhaust pipe 120. In other words, a reduction rate of the cross-sectional area of the sub-pipe 150 relative to the exhaust pipe 120 may be 50% to 90%. The cross-sectional area of the sub-pipe 150 may be proportional to a fourth width W4, and the cross-sectional area of the exhaust pipe 120 may be proportional to a third width W3.

Preferably, the cross-sectional area of the sub-pipe 150 may be reduced by 80% to 90% compared to the cross-sectional area of the exhaust pipe 120. A reduction rate of the cross-sectional area of the sub-pipe 150 relative to the exhaust pipe 120 may be 80% to 90%. As the reduction rate of the cross-sectional area of the sub-pipe 150 relative to the exhaust pipe 120 increases, space efficiency of the semiconductor manufacturing line may be improved.

More preferably, the cross-sectional area of the sub-pipe 150 may be reduced by 85% to 90% compared to the cross-sectional area of the exhaust pipe 120. A reduction rate of the cross-sectional area of the sub-pipe 150 relative to the exhaust pipe 120 may be 85% to 90%. As the reduction rate of the cross-sectional area of the sub-pipe 150 relative to the exhaust pipe 120 increases, space efficiency of the semiconductor manufacturing line may be improved.

When a reduction rate of the cross-sectional area of the sub-pipe 150 relative to the exhaust pipe 120 is less than 50%, space efficiency of the semiconductor manufacturing line may be reduced. On the other hand, when the reduction rate of the cross-sectional area of the sub-pipe 150 relative to the exhaust pipe 120 exceeds 90%, an amount of energy to be output by the second energy controller 160 may increase. Accordingly, a rotation speed of the second rotation module of the second energy controller 160 may become higher. Therefore, stability of the gas control system for semiconductor equipment may be reduced.

In addition, when the reduction rate of the cross-sectional area of the sub-pipe 150 relative to the exhaust pipe 120 exceeds 90%, a flow velocity of the gas passing through the sub-pipe 150 may increase. Accordingly, a load applied to the sub-pipe 150 may also increase. Therefore, stability of the gas control system for semiconductor equipment may be reduced.

That is, by using the gas control system for semiconductor equipment according to some embodiments of the present invention, a semiconductor manufacturing line with improved space efficiency and enhanced stability may be provided.

Although one exhaust pipe 120 and one process chamber 110 are illustrated in FIG. 1, the technical scope of the present invention is not limited thereto. The gas control system for semiconductor equipment may include a plurality of exhaust pipes 120 and a plurality of process chambers 110.

In this case, one sub-pipe 150 and one energy dissipating device 200 may be included, respectively. When so configured, a ratio of a total cross-sectional area of the plurality of exhaust pipes 120 to a cross-sectional area of the sub-pipe 150 at a portion where the sub-pipe 150 is connected to the main pipe 170 may increase, and in this case, energy applied to the main pipe 170 may decrease. Accordingly, the number of process chambers 110 connected to a single main pipe 170 may increase, and space efficiency of the semiconductor manufacturing line utilizing the gas control system for semiconductor equipment may also be improved.

In some embodiments, the gas control system for semiconductor equipment may include the second energy controller 160 and may not include the first energy controller 140. In this case, energy of the gas may be controlled only within the sub-pipe 150. However, the technical scope of the present invention is not limited thereto.

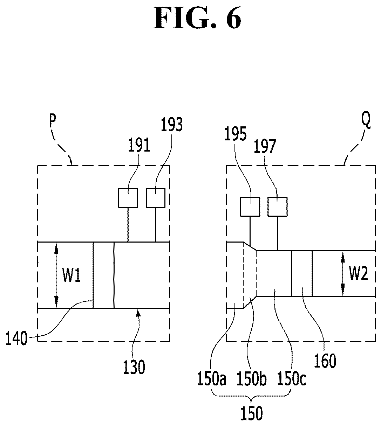

Hereinafter, with reference to FIGS. 6 to 13, gas control systems for semiconductor equipment according to other embodiments of the present invention will be described. For convenience of explanation, descriptions overlapping with those provided with reference to FIGS. 1 to 5 will be briefly explained or omitted.

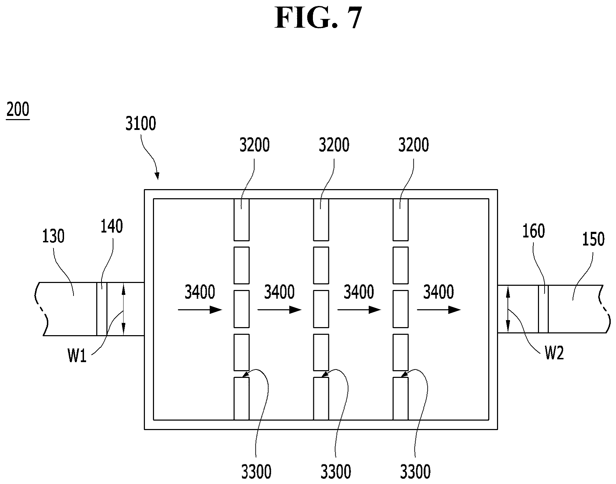

FIGS. 6 to 13 are drawings for explaining the gas control system for semiconductor equipment according to some other embodiments of the present invention. For reference, FIG. 6 may be an exemplary enlarged view of the P region and the Q region of FIG. 1. FIG. 7 may be a drawing for illustrating an energy dissipating device according to other embodiments.

First, referring to FIG. 6, the sub-pipe 150 may include a first portion 150a, a second portion 150b, and a third portion 150c.

The first portion 150a may be closest to the energy dissipating device 200. One end of the first portion 150a may be directly connected to the energy dissipating device 200. The other end of the first portion 150a may be connected to the second portion 150b. The second portion 150b may be interposed between the first portion 150a and the third portion 150c. The third portion 150c may be closest to the main pipe 170. One end of the third portion 150c may be directly connected to the main pipe 170.

In some embodiments, the sub-pipe 150 may include a portion whose width gradually decreases from the energy dissipating device 200 toward the main pipe 170. For example, a width of the second portion 150b may decrease as it becomes farther from the energy dissipating device 200. The width of the second portion 150b may decrease as it becomes closer to the main pipe 170.

A width of the first portion 150a may be the same as a first width W1 of the inlet pipe 130. That is, a flow velocity of the gas passing through the first portion 150a may be the same as a flow velocity of the gas passing through the inlet pipe 130. The flow velocity of the gas may gradually increase from the first portion 150a toward the third portion 150c.

The second energy controller 160 may control energy of the gas, which changes while passing through the first portion 150a and the second portion 150b, to a constant value.

Referring to FIG. 7, the energy dissipating device 200 according to some embodiments may not include a scrubber. The energy dissipating device 200 may include an energy dissipating chamber 3100, at least one tray 3200, and a plurality of tray holes 3300.

First, the chamber 3100 may be provided. The energy dissipating chamber 3100 may be a housing of the energy dissipating device 200. The inlet pipe 130 may be connected to one side of the energy dissipating chamber 3100. The sub-pipe 150 may be connected to the other side of the energy dissipating chamber 3100. That is, gas supplied from the process chamber 110 may be introduced into the energy dissipating chamber 3100 through the inlet pipe 130. The gas may pass through the energy dissipating chamber 3100 and be discharged to the outside through the sub-pipe 150. The gas may move in one direction within the energy dissipating chamber 3100 (see reference numeral 3400).

In some embodiments, the first width W1 of the inlet pipe 130 may be greater than the second width W2 of the sub-pipe 150. However, the technical scope of the present invention is not limited thereto.

At least one tray 3200 may be provided in the energy dissipating chamber 3100. Although three trays 3200 are illustrated in FIG. 7, the technical scope of the present invention is not limited thereto. The number of trays 3200 may be two or less, or four or more. Each tray 3200 may extend in a direction intersecting a flow direction 3400 of the gas. That is, each tray 3200 may extend in a direction perpendicular to the flow direction 3400 of the gas. The trays 3200 may be spaced apart from each other along the flow direction 3400 of the gas.

The plurality of tray holes 3300 may penetrate the tray 3200. The plurality of tray holes 3300 may serve as passages through which the gas flows. The gas may pass through the plurality of tray holes 3300 and be discharged to the outside of the energy dissipating chamber 3100 (see reference numeral 3400).

In some embodiments, the energy of the gas may be dissipated each time the gas passes through the plurality of tray holes 3300. Subsequently, the second energy controller 160 may control the second energy of the gas to a constant value within the sub-pipe 150. Since the energy of the gas is dissipated while passing through the plurality of tray holes 3300, it may be easier for the second energy controller 160 to control the second energy of the gas to a constant value.

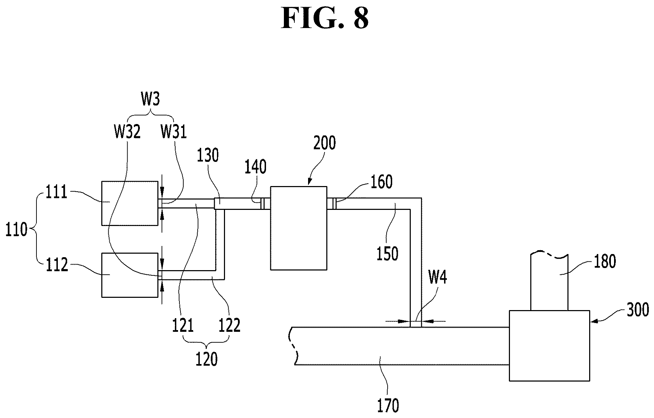

Referring to FIG. 8, the gas control system for semiconductor equipment according to some embodiments may include a plurality of process chambers 110 and a plurality of exhaust pipes 120.

For example, the process chambers 110 may include a first process chamber 111 and a second process chamber 112, and the exhaust pipes 120 may include a first exhaust pipe 121 and a second exhaust pipe 122.

The first semiconductor process may be performed in the first process chamber 111, and the second semiconductor process may be performed in the second process chamber 112. The first semiconductor process and the second semiconductor process may be the same as each other or different from each other.

One end of the first exhaust pipe 121 may be connected to the first process chamber 111, and the other end of the first exhaust pipe 121 may be connected to the inlet pipe 130. One end of the second exhaust pipe 122 may be connected to the second process chamber 112, and the other end of the second exhaust pipe 122 may be connected to the inlet pipe 130. That is, the plurality of exhaust pipes 120 may be connected to a single inlet pipe 130.

When the number of exhaust pipes 120 connected to the inlet pipe 130 increases, the first energy of the gas passing through the inlet pipe 130 may increase. For example, since an amount of the gas passing through the inlet pipe 130 increases, the first static pressure of the gas may increase. When a flow velocity of the gas passing through the inlet pipe 130 increases, the first dynamic pressure of the gas may increase.

In this case, the first energy controller 140 may control the first energy to be constant. When the first energy exceeds the first energy set value, the rotational speed of the first rotation module 140b of the first energy controller 140 may be decreased. When the first pressure of the gas passing through the inlet pipe 130 exceeds the first pressure set value, the rotational speed of the first rotation module 140b of the first energy controller 140 may be decreased.

In some embodiments, the first exhaust pipe 121 may have a third_1 width W31, and the second exhaust pipe 122 may have a third_2 width W32. A sum of the third_1 width W31 and the third_2 width W32 may correspond to a third width W3 of the exhaust pipe 120.

In some embodiments, at a portion where the sub-pipe 150 is connected to the main pipe 170, a ratio of a cross-sectional area of the sub-pipe 150 to a sum of cross-sectional areas of the first exhaust pipe 121 and the second exhaust pipe 122 may be between 2 and 10. That is, a cross-sectional area of the sub-pipe 150 may be reduced by 50% to 90% compared to a cross-sectional area of the exhaust pipes 120. A cross-sectional area of the sub-pipe 150 may be proportional to the fourth width W4. A cross-sectional area of the first exhaust pipe 121 may be proportional to the third_1 width W31. A cross-sectional area of the second exhaust pipe 122 may be proportional to the third_2 width W32. A cross-sectional area of the exhaust pipes 120 may be proportional to the third width W3.

Preferably, a cross-sectional area of the sub-pipe 150 may be reduced by 80% to 90% compared to a cross-sectional area of the exhaust pipes 120. More preferably, the cross-sectional area of the sub-pipe 150 may be reduced by 85% to 90% compared to the cross-sectional area of the exhaust pipes 120.

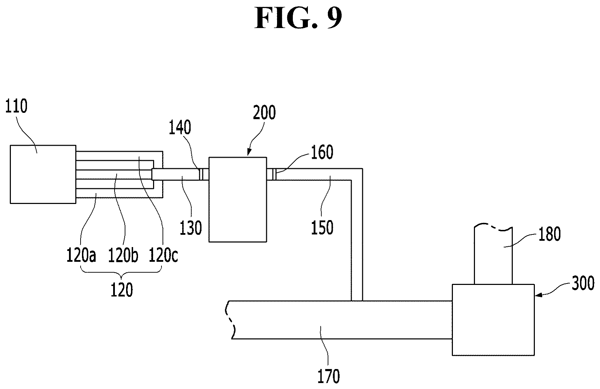

Referring to FIG. 9, the exhaust pipe 120 may include a first sub-exhaust pipe 120a, a second sub-exhaust pipe 120b, and a third sub-exhaust pipe 120c. The first sub-exhaust pipe 120a, the second sub-exhaust pipe 120b, and the third sub-exhaust pipe 120c may all be connected to a single process chamber 110. The first sub-exhaust pipe 120a, the second sub-exhaust pipe 120b, and the third sub-exhaust pipe 120c may all be connected to the inlet pipe 130.

An acidic gas, a neutral gas, and a basic gas may be discharged from the process chamber 110. The acidic gas may be discharged through the first sub-exhaust pipe 120a. The neutral gas may be discharged through the second sub-exhaust pipe 120b. The basic gas may be discharged through the third sub-exhaust pipe 120c.

In some embodiments, the first sub-exhaust pipe 120a, the second sub-exhaust pipe 120b, and the third sub-exhaust pipe 120c may not operate simultaneously. For example, when the gas flows through the first sub-exhaust pipe 120a, the gas may not flow through the second sub-exhaust pipe 120b and the third sub-exhaust pipe 120c. However, the technical scope of the present invention is not limited thereto.

The first sub-exhaust pipe 120a, the second sub-exhaust pipe 120b, and the third sub-exhaust pipe 120c may operate simultaneously, and the gas may be provided to the inlet pipe 130 through the first sub-exhaust pipe 120a, the second sub-exhaust pipe 120b, and the third sub-exhaust pipe 120c. In this case, when the number of the sub-exhaust pipes 120a, 120b, and 120c connected to the inlet pipe 130 increases, the first energy of the gas passing through the inlet pipe 130 may increase. For example, since an amount of the gas passing through the inlet pipe 130 increases, the first static pressure of the gas may increase. When the flow velocity of the gas passing through the inlet pipe 130 increases, the first dynamic pressure of the gas may increase.

In this case, the first energy controller 140 may control the first energy to be constant. When the first energy exceeds the first energy set value, the rotational speed of a first rotation module 140b of the first energy controller 140 may be decreased. When the first pressure of the gas passing through the inlet pipe 130 exceeds the first pressure set value, the rotational speed of the first rotation module 140b of the first energy controller 140 may be decreased.

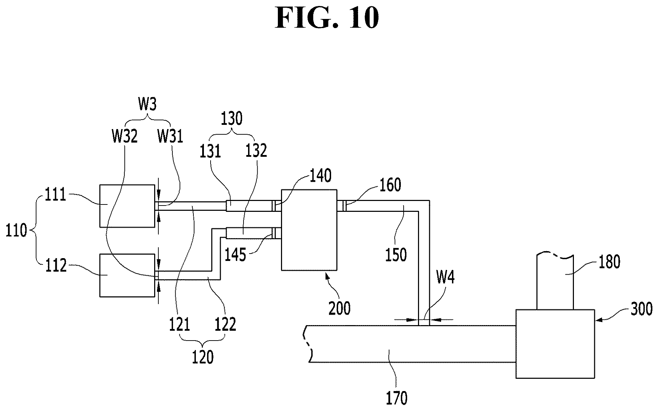

Referring to FIG. 10, the gas control system for semiconductor equipment according to some embodiments may include a plurality of process chambers 110, a plurality of exhaust pipes 120, and a plurality of inlet pipes 130. Additionally, the gas control system for semiconductor equipment according to some embodiments may further include a third energy controller 145.

For example, the process chamber may include a first process chamber 111 and a second process chamber 112. The exhaust pipe 120 may include a first exhaust pipe 121 and a second exhaust pipe 122. The inlet pipe 130 may include a first inlet pipe 131 and a second inlet pipe 132.

The first semiconductor process may be performed in the first process chamber 111, and the second semiconductor process may be performed in the second process chamber 112. The first semiconductor process and the second semiconductor process may be the same as each other or different from each other.

One end of the first exhaust pipe 121 may be connected to the first process chamber 111, and the other end of the first exhaust pipe 121 may be connected to the first inlet pipe 131. One end of the second exhaust pipe 122 may be connected to the second process chamber 112, and the other end of the second exhaust pipe 122 may be connected to the second inlet pipe 132.

The first energy of the gas passing through the first inlet pipe 131 may be identical to a third energy of the gas passing through the second inlet pipe 132. That is, the gas passing through the second inlet pipe 132 may have the third energy. The third energy may include a third pressure energy and a third kinetic energy. The third pressure energy may be proportional to a third pressure of the gas. The third pressure energy may be proportional to a third static pressure of the gas. The third kinetic energy may be proportional to a third flow velocity of the gas. The third kinetic energy may be proportional to a third dynamic pressure of the gas. In other words, the gas may have a third pressure and a third flow velocity inside the second inlet pipe 132, and the third energy of the gas may be defined based on the third pressure and the third flow velocity.

The first energy controller 140 may control the first energy to be constant inside the first inlet pipe 131. For example, the first energy controller 140 may control the first pressure energy of the gas to be constant. The constant value may be between 400 Pa and 800 Pa. Preferably, the constant value may be between 600 Pa and 700 Pa. However, the technical scope of the present invention is not limited thereto.

The third energy controller 145 may control the third energy to be constant inside the second inlet pipe 132. For example, the third energy controller 145 may control the third static energy of the gas to be constant.

In some embodiments, the first energy of the gas passing through the first inlet pipe 131 and the third energy of the gas passing through the second inlet pipe 132 may be identical to each other. The first energy controller 140 and the third energy controller 145 may control the first energy and the third energy to be identical to each other, respectively.

More specifically, the first static energy of the gas passing through the first inlet pipe 131 and the third static energy of the gas passing through the second inlet pipe 132 may be identical to each other.

In contrast, the third kinetic energy of the gas passing through the second inlet pipe 132 may be less than the second kinetic energy of the gas passing through the sub-pipe 150. In other words, the third flow velocity of the gas passing through the second inlet pipe 132 may be less than the second flow velocity of the gas passing through the sub-pipe 150. In other words, the third dynamic pressure of the gas passing through the second inlet pipe 132 may be less than the second dynamic pressure of the gas passing through the sub-pipe 150. This may be because the width of the second inlet pipe 132 is greater than the second width W2 of the sub-pipe 150.

In some embodiments, the first exhaust pipe 121 may have a third_1 width W31, and the second exhaust pipe 122 may have a third_2 width W32. The sum of the third_1 width W31 and the third_2 width W32 may be the third width W3 of the exhaust pipe 120.

In some embodiments, at a portion where the sub-pipe 150 and the main pipe 170 are connected, a ratio of a cross-sectional area of the sub-pipe 150 to a sum of cross-sectional areas of the first exhaust pipe 121 and the second exhaust pipe 122 may be between 2 and 10. In other words, a cross-sectional area of the sub-pipe 150 may be reduced by 50% to 90% compared to a cross-sectional area of the exhaust pipe 120.

A cross-sectional area of the sub-pipe 150 may be proportional to the fourth width W4. A cross-sectional area of the first exhaust pipe 121 may be proportional to the third_1 width W31. A cross-sectional area of the second exhaust pipe 122 may be proportional to the third_2 width W32. A cross-sectional area of the exhaust pipes 120 may be proportional to the third width W3.

Preferably, the cross-sectional area of the sub-pipe 150 may be reduced by 80% to 90% compared to the cross-sectional area of the exhaust pipes 120. More preferably, the cross-sectional area of the sub-pipe 150 may be reduced by 85% to 90% compared to the cross-sectional area of the exhaust pipes 120.

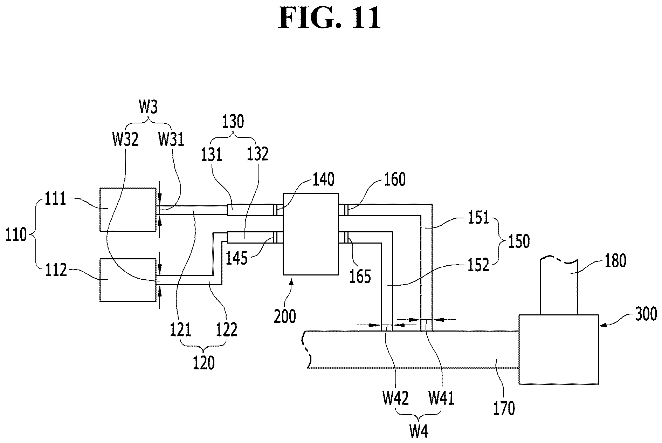

Referring to FIG. 11, the gas control system for semiconductor equipment according to some embodiments may further include a plurality of process chambers 110, a plurality of exhaust pipes 120, a plurality of inlet pipes 130, and a plurality of sub-pipes. In addition, the gas control system for semiconductor equipment according to some embodiments may further include a third energy controller 145 and a fourth energy controller 165.

For example, the process chambers may include a first process chamber 111 and a second process chamber 112. The exhaust pipes 120 may include a first exhaust pipe 121 and a second exhaust pipe 122. The inlet pipes 130 may include a first inlet pipe 131 and a second inlet pipe 132. The sub-pipes 150 may include a first sub-pipe 151 and a second sub-pipe 152.

The first semiconductor process may be performed in the first process chamber 111, and the second semiconductor process may be performed in the second process chamber 112. The first semiconductor process and the second semiconductor process may be the same as each other or different from each other.

One end of the first exhaust pipe 121 may be connected to the first process chamber 111, and the other end of the first exhaust pipe 121 may be connected to the first inlet pipe 131. One end of the second exhaust pipe 122 may be connected to the second process chamber 112, and the other end of the second exhaust pipe 122 may be connected to the second inlet pipe 132.

One end of the first sub-pipe 151 may be connected to the energy dissipating device 200, and the other end of the first sub-pipe 151 may be connected to the main pipe 170. One end of the second sub-pipe 152 may be connected to the energy dissipating device 200, and the other end of the second sub-pipe 152 may be connected to the main pipe 170.

The first energy of the gas passing through the first inlet pipe 131 may be identical to a third energy of the gas passing through the second inlet pipe 132. That is, the gas passing through the second inlet pipe 132 may have the third energy. The third energy may include a third pressure energy and a third kinetic energy. The third pressure energy may be proportional to a third pressure of the gas. The third pressure energy may be proportional to a third static pressure of the gas. The third kinetic energy may be proportional to a third flow velocity of the gas. The third kinetic energy may be proportional to a third dynamic pressure of the gas. In other words, the gas may have a third pressure and a third flow velocity inside the second inlet pipe 132, and the third energy of the gas may be defined based on the third pressure and the third flow velocity.

The first energy controller 140 may control the first energy to be constant inside the first inlet pipe 131. For example, the first energy controller 140 may control the first pressure energy of the gas to be constant. The constant value may be between 400 Pa and 800 Pa. Preferably, the constant value may be between 600 Pa and 700 Pa. However, the technical scope of the present invention is not limited thereto.

The third energy controller 145 may control the third energy to be constant inside the second inlet pipe 142. For example, the third energy controller 145 may control the third pressure energy of the gas to be constant. The constant value may be between 400 Pa and 800 Pa. Preferably, the constant value may be between 600 Pa and 700 Pa. However, the technical scope of the present invention is not limited thereto.

The gas passing through the second sub-pipe 152 may have the fourth energy. The fourth energy may include a fourth pressure energy and a fourth kinetic energy. The fourth pressure energy may be proportional to a fourth pressure of the gas. The fourth pressure energy may be proportional to a fourth static pressure of the gas. The fourth kinetic energy may be proportional to a fourth flow velocity of the gas. The fourth kinetic energy may be proportional to a fourth dynamic pressure of the gas. In other words, the gas may have a fourth pressure and a fourth flow velocity inside the second sub-pipe 152, and the fourth energy of the gas may be defined based on the fourth pressure and the fourth flow velocity.

The second energy controller 160 may control the second energy to be constant inside the first sub-pipe 151. The fourth energy controller 165 may control the fourth energy to be constant inside the second sub-pipe 152.

In some embodiments, the second energy of the gas passing through the first sub-pipe 151 and the fourth energy of the gas passing through the second sub-pipe 152 may be identical to each other. The second energy controller 160 and the fourth energy controller 165 may respectively control the second energy and the fourth energy to be identical to each other.

In contrast, the third kinetic energy of the gas passing through the second inlet pipe 132 may be less than the second kinetic energy of the gas passing through the first sub-pipe 151 and the fourth kinetic energy of the gas passing through the second sub-pipe 152. In other words, the third velocity of the gas passing through the second inlet pipe 132 may be less than the second velocity of the gas passing through the first sub-pipe 151, and the third velocity of the gas passing through the second inlet pipe 132 may be less than the fourth velocity of the gas passing through the second sub-pipe 152.

In other words, the third dynamic pressure of the gas passing through the second inlet pipe 132 may be less than the second dynamic pressure of the gas passing through the sub-pipe 150, and the third velocity of the gas passing through the second inlet pipe 132 may be less than the fourth velocity of the gas passing through the second sub-pipe 152. This may be because a width of the second inlet pipe 132 is greater than a width of the first sub-pipe 151 and a width of the second sub-pipe 152.

In some embodiments, the first exhaust pipe 121 may have a third_1 width W31, and the second exhaust pipe 122 may have a third_2 width W32. A sum of the third_1 width W31 and the third_2 width W32 may be the third width W3 of the exhaust pipe 120. The first sub-pipe 151 may have a fourth_1 width W41, and the second sub-pipe 152 may have a fourth_2 width W42. A sum of the fourth_1 width W41 and the fourth_2 width W42 may be the fourth width W4 of the sub-pipe 150 at a portion where the sub-pipe 150 and the main pipe 170 are connected.

In some embodiments, at a portion where the sub-pipe 150 and the main pipe 170 are connected, a ratio of a sum of cross-sectional areas of the first sub-pipe 151 and the second sub-pipe 152 to a sum of cross-sectional areas of the first exhaust pipe 121 and the second exhaust pipe 122 may be 2 or more and 10 or less. That is, a cross-sectional area of the sub-pipe 150 may be reduced by 50% to 90% relative to a cross-sectional area of the exhaust pipe 120. A cross-sectional area of the first sub-pipe 151 may be proportional to the fourth_1 width W41. A cross-sectional area of the second sub-pipe 152 may be proportional to the fourth_2 width W42. A cross-sectional area of the sub-pipes 150 may be proportional to the fourth width W4. A cross-sectional area of the first exhaust pipe 121 may be proportional to the third_1 width W31. A cross-sectional area of the second exhaust pipe 122 may be proportional to the third_2 width W32. A cross-sectional area of the exhaust pipes 120 may be proportional to the third width W3.

Preferably, a cross-sectional area of the sub-pipe 150 may be reduced by 80% to 90% relative to a cross-sectional area of the exhaust pipe 120. More preferably, a cross-sectional area of the sub-pipe 150 may be reduced by 85% to 90% relative to a cross-sectional area of the exhaust pipe 120.

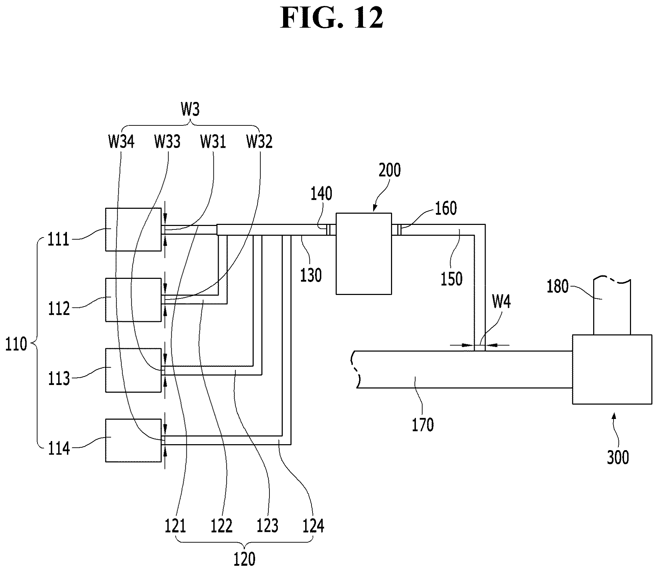

Referring to FIG. 12, the gas control for semiconductor equipment according to some embodiments may include a plurality of process chambers 110 and a plurality of exhaust pipes 120.

For example, the process chamber 110 may include a first process chamber 111, a second process chamber 112, a third process chamber 113, and a fourth process chamber 114, and the exhaust pipe 120 may include a first exhaust pipe 121, a second exhaust pipe 122, a third exhaust pipe 123, a fourth exhaust pipe 124.

The first semiconductor process may be performed in the first process chamber 111. The second semiconductor process may be performed in the second process chamber 112. The third semiconductor process may be performed in the third process chamber 113. The fourth semiconductor process may be performed in the fourth process chamber 114. The first to fourth semiconductor processes may be the same as each other or different from each other.

One end of the first exhaust pipe 121 may be connected to the first process chamber 111, and the other end of the first exhaust pipe 121 may be connected to the inlet pipe 130. One end of the second exhaust pipe 122 may be connected to the second process chamber 112, and the other end of the second exhaust pipe 122 may be connected to the inlet pipe 130. One end of the third exhaust pipe 123 may be connected to the third process chamber 113, and the other end of the third exhaust pipe 123 may be connected to the inlet pipe 130. One end of the fourth exhaust pipe 124 may be connected to the fourth process chamber 114, and the other end of the fourth exhaust pipe 124 may be connected to the inlet pipe 130. That is, the plurality of exhaust pipes 120 may be connected to a single inlet pipe 130.

When the number of exhaust pipes 120 connected to the inlet pipe 130 increases, the first energy of the gas passing through the inlet pipe 130 may increase. For example, since an amount of the gas passing through the inlet pipe 130 increases, the first static pressure of the gas may increase. When a flow velocity of the gas passing through the inlet pipe 130 increases, the first dynamic pressure of the gas may increase.

In this case, the first energy controller 140 may control the first energy to be constant. When the first energy exceeds the first energy set value, the rotational speed of the first rotation module 140b of the first energy controller 140 may be decreased.

In some embodiments, the first exhaust pipe 121 may have a third_1 width W31, the second exhaust pipe 122 may have a third_2 width W32, the third exhaust pipe 123 may have a third_3 width W33, and the fourth exhaust pipe 124 may have a third_4 width W34. The sum of the third_1 width W31, the third_2 width W32, the third_3 width W33, and the third_4 width W34 may be the third width W3 of the exhaust pipe 120. The ratio of the fourth width W4 to the third width W3 may be 1.4 or more and 3.2 or less, but the technical scope of the present invention is not limited thereto.

In some embodiments, at a connection portion between the sub-pipe 150 and the main pipe 170, a ratio of a cross-sectional area of the sub-pipe 150 to a sum of cross-sectional areas of the first exhaust pipe 121, the second exhaust pipe 122, the third exhaust pipe 123, and the fourth exhaust pipe 124 may be between 2 and 10. In other words, a cross-sectional area of the sub-pipe 150 may be reduced by 50% to 90% relative to a cross-sectional area of the exhaust pipes 120.

The cross-sectional area of the sub-pipe 150 may be proportional to the fourth width W4. The cross-sectional area of the first exhaust pipe 121 may be proportional to the third_1 width W31. The cross-sectional area of the second exhaust pipe 122 may be proportional to the third_2 width W32. The cross-sectional area of the third exhaust pipe 123 may be proportional to the third_3 width W33. The cross-sectional area of the fourth exhaust pipe 124 may be proportional to the third_4 width W34. The cross-sectional area of the exhaust pipes 120 may be proportional to the third width W3.

Preferably, the cross-sectional area of the sub-pipe 150 may be reduced by 80% to 90% relative to the cross-sectional area of the exhaust pipes 120. More preferably, the cross-sectional area of the sub-pipe 150 may be reduced by 85% to 90% relative to the cross-sectional area of the exhaust pipes 120.

In FIG. 12, the gas control system for semiconductor equipment is illustrated as including one main pipe 170 and four process chambers 110, but the technical scope of the present invention is not limited thereto. In other embodiments of the present invention, the gas control system for semiconductor equipment may include one main pipe 170 and twenty-four process chambers 110. As the number of process chambers 110 relative to the number of main pipes 170 increases, a semiconductor production line with improved spatial efficiency may be provided.

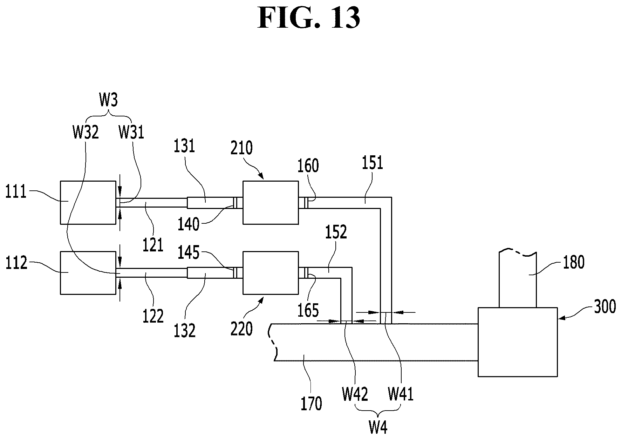

Referring to FIG. 13, the gas control system for semiconductor equipment according to some embodiments may include first and second process chambers 111 and 112, first and second exhaust pipes 121 and 122, first and second inlet pipes 131 and 132, first and second energy dissipating devices 210 and 220, and first and second sub-pipes 151 and 152.

Also, the gas control system for semiconductor equipment according to some embodiments may include a third energy controller 145 and a fourth energy controller 165.

Accordingly, the process chamber, the exhaust pipe, the inlet pipe, the energy dissipating device, and the sub-pipe may each correspond one-to-one.

Specifically, the first process chamber 111 is connected to the first exhaust pipe 121, the first exhaust pipe 121 is connected to the first inlet pipe 131. The first inlet pipe 131 is connected to the first energy dissipating device 210. The first sub-pipe 151 is connected to the first energy dissipating device 210.

The first energy controller 140 may control the energy of the gas flowing through the first inlet pipe 131 to a constant value. The second energy controller 160 may control the energy of the gas flowing through the first sub-pipe 151 to a constant value.

The second process chamber 112 is connected to the second exhaust pipe 122, the second exhaust pipe 122 is connected to the second inlet pipe 132. The second inlet pipe 132 is connected to the second energy dissipating device 220. The second sub-pipe 152 is connected to the second energy dissipating device 220.

The third energy controller 145 may control the energy of the gas flowing through the second inlet pipe 132 to a constant value. The fourth energy controller 165 may control the energy of the gas flowing through the second sub-pipe 152 to a constant value.

In some embodiments, the first exhaust pipe 121 may have a third_1 width W31, the second exhaust pipe 122 may have a third_2 width W32. A sum of the third_1 width W31 and the third_2 width W32 may be the third width W3 of the exhaust pipe 120. The first sub-pipe 151 may have a fourth_1 width W41, the second sub-pipe 152 may have a fourth_2 width W42. A sum of the fourth_1 width W41 and the fourth_2 width W42 may be the fourth width W4 of the sub-pipe 150 at a portion where the sub-pipe 150 and the main pipe 170 are connected.

The ratio of the fourth width W4 to the third width W3 may be 1.4 or more and 3.2 or less, but the technical scope of the present invention is not limited thereto.

In some embodiments, at a portion where the sub-pipe 150 is connected to the main pipe 170, a ratio of a cross-sectional area of the sub-pipe 150 to a sum of cross-sectional areas of the first exhaust pipe 121 and the second exhaust pipe 122 may be between 2 and 10. That is, a cross-sectional area of the sub-pipe 150 may be reduced by 50% to 90% compared to a cross-sectional area of the exhaust pipes 120.

A cross-sectional area of the first sub-pipe 151 may be proportional to the fourth_1 width W41. A cross-sectional area of the second sub-pipe 152 may be proportional to the fourth_2 width W42. A cross-sectional area of the sub-pipes 150 may be proportional to the fourth width W4. A cross-sectional area of the first exhaust pipe 121 may be proportional to the third_1 width W31. A cross-sectional area of the second exhaust pipe 122 may be proportional to the third_2 width W32. A cross-sectional area of the exhaust pipes 120 may be proportional to the third width W3.

Preferably, a cross-sectional area of the sub-pipe 150 may be reduced by 80% to 90% compared to a cross-sectional area of the exhaust pipes 120. More preferably, the cross-sectional area of the sub-pipe 150 may be reduced by 85% to 90% compared to the cross-sectional area of the exhaust pipes 120.

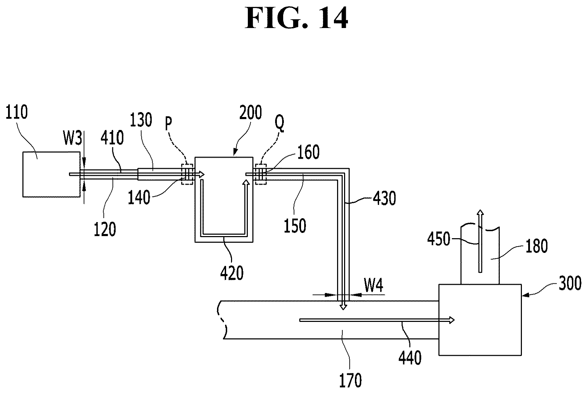

Hereinafter, with reference to FIG. 14, a method of operating a gas control system for semiconductor equipment according to some embodiments of the present invention will be described. FIG. 14 is drawing for explaining an operating method of a gas control system for semiconductor equipment according to some embodiments of the present invention.

Referring to FIG. 14, first, the process chamber 110 may be provided. The semiconductor process may be performed in the process chamber 110. For example, the semiconductor process may include the deposition process, the etching process and/or cleaning process, but technical scope of the present invention is not limited thereto.

The gas used in the semiconductor process may be discharged to the outside of the process chamber 110 through the exhaust pipe 120. The gas may move to the energy dissipating device 200 via the exhaust pipe 120 and the inlet pipe 130 (see reference numeral 410). The gas may have a first energy inside the inlet pipe 130, and the first energy may include a first pressure energy and a first kinetic energy.

The first energy controller 140 may control the first energy to a predetermined value. Since the first energy is controlled to the predetermined value, the process chamber 110 connected to the inlet pipe 130 may operate stably. Specifically, the first energy of the gas may be controlled by adjusting the first pressure and the first velocity of the gas. The first energy of the gas may be controlled by adjusting the rotation speed of the first rotation module 140b of the first energy controller 140.

The gas supplied to the energy dissipating device 200 may lose energy while passing through the energy dissipating device 200 (see reference numeral 420). For example, the gas may pass through the first scrubbing hole (2300u of FIG. 3). As the gas passes through the first scrubbing hole (2300u of FIG. 3), the energy of the gas may be consumed. In addition, when the energy dissipating device 200 includes a scrubber, the impurities contained in the gas may be dissolved into the scrubbing solution (2270 of FIG. 3) on the upper surface of the first scrubbing plate (2300 of FIG. 3) after the gas passes through the first scrubbing hole (2300u of FIG. 3).

The gas that has passed through the energy dissipating device 200 may be discharged to the outside of the energy dissipating device 200 through the sub-pipe 150. Since the energy of the gas is reduced inside the energy dissipating device 200, the energy of the gas inside the energy dissipating device 200 may be less than the first energy of the gas inside the inlet pipe 130.

The gas may pass through the sub-pipe 150 and be supplied to the main pipe 170 (see reference numeral 430). Since the energy of the gas is reduced while passing through the energy dissipating device 200, additional energy may be required for the gas to move to the main pipe 170. The second energy controller 160 may additionally supply energy to the gas. That is, the second energy controller 160 may regulate the second energy of the gas within the sub-pipe 150 to a constant level. The second energy may be the minimum energy required for the gas to move to the main pipe 170.

Specifically, the second energy of the gas may be controlled by adjusting the second pressure and the second velocity of the gas. The second energy of the gas may be regulated by adjusting the rotation speed of the second rotation module of the second energy controller 160.

The gas may pass through the main pipe 170 and be supplied to the utility duct 300 (see reference numeral 440), and the gas may be discharged to the outside of the semiconductor production line through the utility pipe 180 (see reference numeral 450).

When the gas control system for semiconductor equipment according to some embodiments of the present invention is used, the second energy of the gas passing through the sub-pipe 150 may be adjusted to a constant value. Accordingly, the load applied to the main pipe 170 may be reduced. As a result, the number of process chambers 110 connected to the main pipe 170 may be increased, and the spatial efficiency of the semiconductor production line may be improved.

Although the embodiments of the present invention have been described with reference to the attached drawings, the present invention is not limited to the embodiments described above, but can be manufactured in various different forms, and a person having ordinary skill in the art to which the present invention pertains will understand that the present invention can be implemented in other specific forms without changing the technical scope or essential features of the present invention. Therefore, it should be understood that the embodiments described above are exemplary in all respects and not restrictive.

## Claims

1. A gas control system for semiconductor equipment, comprising:
a first process chamber in which a first semiconductor process is performed;
a first exhaust pipe connected to the first process chamber and through which gas used in the first semiconductor process is discharged;
a first inlet pipe connected to the first exhaust pipe;
an energy dissipating device connected to the first inlet pipe to dissipate energy of the gas supplied through the first inlet pipe;
a sub-pipe through which the gas having passed through the energy dissipating device is discharged;
a main pipe connected to the sub-pipe;
a first energy controller disposed in the first inlet pipe to control a first energy of the gas passing through the first inlet pipe; and
a second energy controller disposed in the sub-pipe to control a second energy of the gas passing through the sub-pipe,
wherein the gas is supplied to the energy dissipating device through the first exhaust pipe and the first inlet pipe,
wherein thereafter the gas is discharged to the outside through the sub-pipe and the main pipe,
wherein the first energy of the gas in the first inlet pipe is controlled to a constant value by the first energy controller, and
wherein the second energy of the gas in the sub-pipe is controlled to a constant value by the second energy controller.

2. The gas control system for semiconductor equipment of claim 1, wherein the first energy comprises a first pressure energy and a first kinetic energy, and
wherein the first energy controller controls the first pressure energy of the gas to a constant value.

3. The gas control system for semiconductor equipment of claim 2, wherein the second energy comprises a second pressure energy and a second kinetic energy, and
wherein the first kinetic energy of the gas in the first inlet pipe is less than the second kinetic energy of the gas in the sub-pipe.

4. The gas control system for semiconductor equipment of claim 1, wherein a width of the first inlet pipe is greater than a width of the sub-pipe.

5. The gas control system for semiconductor equipment of claim 1, wherein the sub-pipe includes a section whose width gradually decreases from the energy dissipating device toward the main pipe.

6. The gas control system for semiconductor equipment of claim 1, wherein the energy dissipating device comprises a scrubber,
the scrubber comprising:
a scrubbing chamber defining a scrubbing space for scrubbing impurities contained in the gas;
a scrubbing plate disposed in the scrubbing chamber; and
a plurality of scrubbing holes penetrating the scrubbing plate,
wherein the gas loses energy while passing through the plurality of scrubbing holes.

7. The gas control system for semiconductor equipment of claim 6, further comprising a solution supply nozzle supplying a scrubbing solution onto an upper surface of the scrubbing plate, and
wherein at least a portion of the impurities contained in the gas dissolves into the scrubbing solution on the upper surface of the scrubbing plate after the gas ascends through the plurality of scrubbing holes.

8. The gas control system for semiconductor equipment of claim 1, further comprising:
a second process chamber different from the first process chamber, in which a second semiconductor process is performed;
a second exhaust pipe connected to the second process chamber and through which gas used in the second semiconductor process is discharged;
a second inlet pipe having one end connected to the second exhaust pipe and the other end connected to the energy dissipating device; and
a third energy controller disposed in the second inlet pipe to control a third energy of the gas passing through the second inlet pipe,
wherein the first energy includes a first pressure energy and a first kinetic energy,
wherein the third energy includes a third pressure energy and a third kinetic energy, and
wherein the first pressure energy and the third pressure energy are equal.

9. The gas control system for semiconductor equipment of claim 8, wherein the second energy includes a second pressure energy and a second kinetic energy, and
wherein the third kinetic energy of the gas in the second inlet pipe is less than the second kinetic energy of the gas in the sub-pipe.

10. The gas control system for semiconductor equipment of claim 1, further comprising:
a second process chamber different from the first process chamber, in which a second semiconductor process is performed, and
a second exhaust pipe having one end connected to the second process chamber and the other end connected to the first inlet pipe, the second exhaust pipe discharging gas used in the second semiconductor process.

11. The gas control system for semiconductor equipment of claim 1, further comprising a first pressure sensor measuring a first pressure of the gas passing through the first inlet pipe,
wherein the first energy controller includes a first rotation module capable of rotating,
wherein when an absolute value of the first pressure measured by the first pressure sensor is greater than a first pressure set value, a rotation speed of the first rotation module is reduced, and
wherein when the absolute value of the first pressure measured by the first pressure sensor is less than the first pressure set value, the rotation speed of the first rotation module is increased.

12. The gas control system for semiconductor equipment of claim **11,** further comprising a second pressure sensor measuring a second pressure of the gas passing through the sub-pipe,
wherein the second energy controller includes a second rotation module capable of rotating,
wherein when an absolute value of the second pressure measured by the second pressure sensor is greater than a second set value, a rotation speed of the second rotation module is reduced, and
wherein when the absolute value of the second pressure measured by the second pressure sensor is less than the second set value, the rotation speed of the second rotation module is increased.

13. The gas control system for semiconductor equipment of claim 12, wherein the first pressure remains constant even if the rotation speed of the second rotation module is changed.

14. A gas control system for semiconductor equipment, comprising:
a plurality of process chambers in which semiconductor processes are performed;
a plurality of exhaust pipes connected respectively to the plurality of process chambers and discharging gas used in the semiconductor processes performed in the plurality of process chambers;
an inlet pipe connected to all of the plurality of exhaust pipes;
an energy dissipating device connected to the inlet pipe to dissipate energy of the gas supplied through the inlet pipe;
a sub-pipe through which the gas having passed through the energy dissipating device is discharged;
a main pipe connected to the sub-pipe; and
an energy controller disposed in the sub-pipe to control energy of the gas passing through the sub-pipe,
wherein the gas is supplied to the energy dissipating device through the plurality of exhaust pipes and the inlet pipe,
wherein thereafter the gas is discharged to the outside through the sub-pipe and the main pipe, and
wherein a ratio of a sum of cross-sectional areas of the plurality of exhaust pipes to a cross-sectional area of the sub-pipe at a connection portion between the main pipe and the sub-pipe is between 2 and 10.

15. The gas control system for semiconductor equipment of claim 14, wherein a cross-sectional area of the sub-pipe remains constant from the energy dissipating device toward the main pipe.

16. The gas control system for semiconductor equipment of claim 14, wherein the energy dissipating device comprises a scrubber,
the scrubber comprising:
a scrubbing chamber defining a scrubbing space for scrubbing impurities contained in the gas;
a scrubbing plate disposed in the scrubbing chamber; and
a plurality of scrubbing holes penetrating the scrubbing plate,
wherein the gas loses energy while passing through the plurality of scrubbing holes.

17. The gas control system for semiconductor equipment of claim 16, further comprising a solution supply nozzle supplying a scrubbing solution onto an upper surface of the scrubbing plate, and
wherein at least a portion of the impurities contained in the gas dissolves into the scrubbing solution on the upper surface of the scrubbing plate after the gas ascends through the plurality of scrubbing holes.

18. A gas control system for semiconductor equipment, comprising:
a process chamber in which a semiconductor process is performed;
an exhaust pipe connected to the process chamber and through which gas used in the semiconductor process is discharged;
an inlet pipe connected to the exhaust pipe;
an energy dissipating device connected to the inlet pipe to dissipate energy of the gas supplied through the inlet pipe;
a sub-pipe through which the gas having passed through the energy dissipating device is discharged;
a main pipe connected to the sub-pipe;
a velocity sensor that measures a flow velocity of the gas passing through the sub-pipe;
a pressure sensor that measures a pressure of the gas passing through the sub-pipe; and
an energy controller disposed in the sub-pipe to control energy of the gas passing through the sub-pipe and including a rotation module capable of rotating,
wherein the gas is supplied to the energy dissipating device through the exhaust pipe and the inlet pipe,
wherein thereafter the gas is discharged to the outside through the sub-pipe and the main pipe,
wherein the energy of the gas includes a pressure energy and a kinetic energy,
wherein the kinetic energy of the gas is proportional to the flow velocity of the gas,
wherein the pressure energy of the gas is proportional to the pressure of the gas,
wherein the kinetic energy of the gas is calculated based on the flow velocity measured by the velocity sensor,
wherein the pressure energy of the gas is calculated based on the pressure measured by the pressure sensor,
wherein when a sum of the kinetic energy and the pressure energy of the gas exceeds a preset value, a rotation speed of the rotation module of the energy controller is reduced, and
wherein when the sum of the kinetic energy and the pressure energy of the gas is less than the preset value, the rotation speed of the rotation module of the energy controller is increased.

19. The gas control system for semiconductor equipment of claim 18, wherein the energy dissipating device comprises a scrubber,
the scrubber comprising:
a scrubbing chamber defining a scrubbing space for scrubbing impurities contained in the gas;
a scrubbing plate disposed in the scrubbing chamber; and
a plurality of scrubbing holes penetrating the scrubbing plate,
wherein the gas loses energy while passing through the plurality of scrubbing holes.

20. The gas control system for semiconductor equipment of claim 19, further comprising a solution supply nozzle supplying a scrubbing solution onto an upper surface of the scrubbing plate, and
wherein at least a portion of the impurities contained in the gas dissolves into the scrubbing solution on the upper surface of the scrubbing plate after the gas ascends through the plurality of scrubbing holes.
